# EUROPEAN PATENT APPLICATION

(11) **EP 4 567 484 A1**
(43) Date of publication of application: **11.06.2025**
(21) Application number: 23856246.6
(22) Date of filing: 25.06.2023
(51) Int. Cl.: G02B 6/42, G02B 6/32

(54) **TRANSISTOR-OUTLINE PACKAGE AND PREPARATION METHOD THEREFOR, OPTICAL DEVICE, OPTICAL MODULE, AND OPTICAL COMMUNICATION SYSTEM**

(30) Priority: 25.08.2022 CN 202211028376
(71) Applicant: Huawei Technologies Co., Ltd., Shenzhen, Guangdong 518129 (CN)
(72) Inventor: GE, Zhaojiang, Shenzhen, Guangdong 518129 (CN); WAN, Zhengwen, Shenzhen, Guangdong 518129 (CN); CHENG, Yongshi, Shenzhen, Guangdong 518129 (CN); GAO, Fei, Shenzhen, Guangdong 518129 (CN); DONG, Hao, Shenzhen, Guangdong 518129 (CN); ZHOU, Yaling, Shenzhen, Guangdong 518129 (CN)
(74) Representative: Thun, Clemens
(86) International application number: PCT/CN2023/102183
(87) International publication number: WO 2024/041154

(57) **Abstract**

This application provides a transistor outline package and a production method thereof, an optical sub-assembly, an optical module, and an optical communication system. The transistor outline package includes an accommodation cavity formed by a transistor cap and a transistor base. A main lens is disposed on a top of the transistor cap and runs through the transistor cap, and is configured to transmit a total light ray. The total light ray includes a first light ray and a second light ray. A first chip, a second chip, and an optical splitting component are disposed in the accommodation cavity. The first light ray is transmitted between the first chip and the main lens, and the first chip is an optical transmitter chip. The second light ray is transmitted between the second chip and the main lens. The optical splitting component is disposed between the first chip and the main lens and is configured to adjust a transmission direction of the first light ray, and the optical splitting component is further disposed between the second chip and the main lens and is configured to adjust a transmission direction of the second light ray, so that the first light ray and the second light ray between the optical splitting component and the main lens can be converged into the total light ray. The transistor outline package is integrated with at least two chips to improve integration of the transistor outline package.

## Description

### CROSS-REFERENCE TO RELATED APPLICATIONS

This application claims priority to Chinese Patent Application No. 202211028376.4, filed with the China National Intellectual Property Administration on August 25, 2022 and entitled "TRANSISTOR OUTLINE PACKAGE AND PRODUCTION METHOD THEREOF, OPTICAL SUB-ASSEMBLY, OPTICAL MODULE, AND OPTICAL COMMUNICATION SYSTEM", which is incorporated herein by reference in its entirety.

### TECHNICAL FIELD

This application relates to the field of optical sub-assembly technologies, and in particular, to a transistor outline package and a production method thereof, an optical sub-assembly, an optical module, and an optical communication system.

### BACKGROUND

An optical sub-assembly is a main component of an optical module. Packages of the optical sub-assembly mainly include forms such as a coaxial package, a box package, and a chip on board (COB) package. A transistor outline (TO) package is a basic package structure of a coaxial-type optical sub-assembly. A conventional TO package includes a transmit type and a receive type. Usually, one TO package has only one laser diode (LD) or Photo diode (PD), and can only receive or transmit a single-channel/single-wavelength signal. However, based on different functions, quantities, and assembly structures of a TO package integrated with a coaxial optical sub-assembly, conventional coaxial optical sub-assemblies are mainly divided into single-fiber unidirectional sub-assemblies, single-fiber bidirectional sub-assemblies (BOSA), and single-fiber triplexer or single-fiber quadruplexer sub-assemblies integrated with TO packages at more receive and transmit ends. The unidirectional components may include an optical transmit component (TOSA) or an optical receive component (ROSA). Coaxial-type component packages are relatively simple and have relatively low costs, and therefore, are widely applied to optical sub-assembly products in fields such as passive optical network (PON), wireless network, and internet protocol (IP).

In a conventional technology, the optical sub-assembly needs to be integrated with many TO packages to implement signal transmission on more channels. Limited by a size of a conventional TO package and a capability of a lens, a package size of the optical sub-assembly needs to be increased, and a complex optical path solution such as parallel light or a relay lens is used, combined with use of more external lenses and optical filters. Consequently, an overall difficulty in designing a structure and manufacturing an optical sub-assembly increases. As a result, material costs and production costs are high, and it is difficult to meet a requirement of a miniaturized module packaging protocol.

### SUMMARY

This application provides a transistor outline package and a production method thereof, an optical sub-assembly, an optical module, and an optical communication system. The transistor outline package can be configured to transmit at least two light rays to implement wavelength division multiplexing. In this case, the transistor outline package can transmit at least two signals to improve integration of the transistor outline package.

According to a first aspect, this application provides a transistor outline package. The transistor outline package includes a transistor base, a transistor cap, a main lens, a first chip, a second chip, and an optical splitting component. The transistor cap is disposed on the transistor base, so that the transistor cap and the transistor base form an accommodation cavity. The main lens is disposed on a top of the transistor cap, and the main lens runs through the transistor cap. The main lens is configured to transmit a total light ray of the transistor outline package. The total light ray includes a first light ray and a second light ray, in other words, the first light ray and the second light ray may be combined into the total light ray for transmission along one path. The first chip, the second chip, and the optical splitting component are disposed in the accommodation cavity. The first light ray is transmitted between the first chip and the main lens, and the first chip is an optical transmitter chip, in other words, the first light ray is emitted from the first chip to the main lens, and is emitted out of the transistor outline package through the main lens. The second light ray is transmitted between the second chip and the main lens. A position of the first chip is different from a position of the second chip. To enable that the first light ray and the second light ray can be converged into the total light ray, the optical splitting component is disposed. The optical splitting component is disposed between the first chip and the main lens and is configured to adjust a transmission direction of the first light ray; and in addition, the optical splitting component is disposed between the second chip and the main lens and is configured to adjust a transmission direction of the second light ray. Therefore, the first light ray and the second light ray between the optical splitting component and the main lens can be converged into the total light ray, so that at least two light rays can be transmitted by using one optical fiber, in other words, one transistor outline package can be configured to transmit at least two light rays to implement wavelength division multiplexing. The foregoing transistor outline package is integrated with at least two chips, and all light rays of the transistor outline package are transmitted by using one main lens. In this case, the transistor outline package can transmit at least two signals to improve integration of the transistor outline package.

In a further technical solution, the transistor outline package further includes a first lens and a second lens. The first lens and the second lens are also disposed in the accommodation cavity. Specifically, the first lens is disposed between the first chip and the main lens and is configured to collimate the first light ray or converge the first light ray, and the second lens is disposed between the second chip and the main lens and is configured to collimate the second light ray or converge the second light ray. This solution can improve a parallelism degree and a coincidence degree between the first ray and the second ray, and improve signal transmission accuracy.

When the first lens and the second lens are specifically disposed, the first lens and the second lens may be integrated. This solution helps reduce a quantity of accessories of the transistor outline package, facilitates manufacturing and assembly of the first lens and the second lens, and helps reduce a volume of the transistor outline package.

In another technical solution, the first lens, the second lens, and the optical splitting component may further be integrated. This solution can further reduce the quantity of accessories of the transistor outline package, simplify an assembly process of the transistor outline package, and also help reduce the volume of the transistor outline package.

When the optical splitting component is mounted, in a technical solution, the optical splitting component may be mounted on the transistor base. Specifically, the transistor base may be enabled to have a mechanical part, and the optical splitting component is mounted on the mechanical part. Alternatively, in another technical solution, the optical splitting component may be mounted on the first lens or the second lens. This solution helps reduce the volume of the transistor outline package. In addition, the optical splitting component in this solution is in a mounting relationship with the first lens and the second lens. Therefore, before mounting, it is convenient to adjust a position to improve accuracy of transmission paths of the first light ray and the second light ray.

A positional relationship between the first chip and the second chip is not limited in this application. For example, in a technical solution, the first chip and the second chip may be located on two neighboring sides of the optical splitting component. The first light ray between the optical splitting component and the first chip may be perpendicular to the second light ray between the optical splitting component and the second chip.

Alternatively, in another technical solution, the first chip and the second chip may be located on a same side of the optical splitting component. Alternatively, in still another technical solution, the first chip and the second chip may be located on two opposite sides of the optical splitting component. In the foregoing two technical solutions, the first light ray between the optical splitting component and the first chip may be parallel to the second light ray between the optical splitting component and the second chip.

When the first chip and the second chip are specifically disposed, the first chip and the second chip may be disposed on a same surface. In this way, a tolerance between a mounting plane of the first chip and a mounting plane of the second chip is reduced, and positions of the first chip and the second chip are conveniently adjusted, so that a coincidence degree between a total light ray of the first light ray and the second light ray between the optical splitting component and the main lens is higher, and signal transmission accuracy of the transistor outline package is higher.

A specific type and structure of the optical splitting component are not limited. Specifically, the optical splitting component may include at least one of an optical filter, an optical splitter, a planar lightwave, a light splitting prism, or a rhomboid prism optical splitter. For example, the optical splitting component may include any one of the optical filter, the optical splitter, the planar lightwave, the light splitting prism, or the rhomboid prism optical splitter; the optical splitting component may include two or more optical filters; the optical splitting component may include a combination of the light splitting prism and the optical filter; or the optical splitting component may include a combination of the optical filter and the rhomboid prism optical splitter. This is not limited in this application.

In a specific technical solution, a specific type of the second chip is not limited. The second chip is an optical receiver chip. In this case, the transistor outline package is a transistor outline package integrated with a receiving component and a sending component. Alternatively, the second chip may be an optical transmitter chip. In this case, the transistor outline package is a transistor outline package integrated with two sending components.

In addition, in another technical solution, the total light ray may further include a third light ray. Correspondingly, the transistor outline package further includes a third chip, and the third chip is also disposed in the accommodation cavity. A third light ray is transmitted between the third chip and the main lens. In addition, the optical splitting component is further disposed between the third chip and the main lens and is configured to adjust a transmission direction of the third light ray. In this solution, the third light ray, the first light ray, and the second light ray can be combined into a total light ray on a side of the optical splitting component towards the main lens. This solution can further improve integration of the transistor outline package, and help reduce the volume of the optical sub-assembly.

In still another technical solution, the total light ray may further include a fourth light ray. Correspondingly, the transistor outline package further includes a fourth chip, and the fourth chip is also disposed in the accommodation cavity. A fourth light ray is transmitted between the fourth chip and the main lens. In addition, the optical splitting component is further disposed between the fourth chip and the main lens and is configured to adjust a transmission direction of the fourth light ray. In this solution, the fourth light ray, the first light ray, and the second light ray can be combined into a total light ray on a side of the optical splitting component towards the main lens. This solution can further improve integration of the transistor outline package, and help reduce the volume of the optical sub-assembly.

In a technical solution, the first chip and the second chip are optical transmitter chips, and the third chip and the fourth chip are optical receiver chips. The transistor outline package in this solution is a transistor outline package integrated with two sending components and two receiving components.

According to a second aspect, this application further provides the production method for the transistor outline package according to the first aspect. The production method includes: fastening the optical splitting component to the transistor base; presetting the first chip and the second chip on the transistor base; adjusting a position of the first chip based on a flare of the first light ray or an optical power of the first light ray, and fastening the first chip when the flare of the first light ray is located at a first preset position or the optical power of the first light ray reaches a first preset optical power; adjusting a position of the second chip based on a flare of the second light ray or an optical power of the second light ray, and fastening the second chip when the flare of the second light ray is located at a second preset position or the optical power of the second light ray reaches a second preset power; and mounting the transistor cap on the transistor base.

In this solution, the transistor outline package is actively assembled. The positions of the first chip and the second chip may be adjusted based on actual situations to ensure a coincidence degree between the first light ray and the second light ray.

According to a third aspect, this application further provides another production method for the transistor outline package according to the first aspect. When the transistor outline package further includes a first lens and a second lens, the first lens is disposed between the first chip and the main lens and is configured to adjust a transmission direction of the first light ray, and the second lens is disposed between the second chip and the main lens and is configured to adjust a transmission direction of the second light ray. The production method includes: fastening the optical splitting component, the first lens, and the second lens to the transistor base; presetting the first chip and the second chip on the transistor base; adjusting a position of the first chip based on a flare of the first light ray or an optical power of the first light ray, and fastening the first chip when the flare of the first light ray is located at a first preset position or the optical power of the first light ray reaches a first preset optical power; adjusting a position of the second chip based on a flare of the second light ray or a power of the second light ray, and fastening the second chip when the flare of the second light ray is located at a second preset position or the optical power of the second light ray reaches a second preset optical power; and mounting the transistor cap on the transistor base.

Similarly, in this solution, the transistor outline package is actively assembled. The positions of the first chip and the second chip may be adjusted based on actual situations to ensure a coincidence degree between the first light ray and the second light ray.

According to a fourth aspect, this application further provides another production method for the transistor outline package according to the first aspect. When the transistor outline package further includes a first lens and a second lens, the first lens is disposed between the first chip and the main lens and is configured to adjust a transmission direction of the first light ray, and the second lens is disposed between the second chip and the main lens and is configured to adjust a transmission direction of the second light ray. The production method includes: fastening the optical splitting component, the first chip, and the second chip to the transistor base; presetting the first lens and the second lens on the transistor base; adjusting a position of the first lens based on a flare of the first light ray or an optical power of the first light ray, and fastening the first lens when the flare of the first light ray is located at a first preset position or the optical power of the first light ray reaches a first preset optical power; adjusting a position of the second lens based on a flare of the second light ray or an optical power of the second light ray, and fastening the second lens when the flare of the second light ray is located at a second preset position or the optical power of the second light ray reaches a second preset power; and mounting the transistor cap on the transistor base.

In this solution, the transistor outline package is actively assembled. The positions of the first lens and the second lens may be adjusted based on actual situations to ensure a coincidence degree between the first light ray and the second light ray.

According to a fifth aspect, this application further provides an optical sub-assembly. The optical sub-assembly includes a transistor and at least one transistor outline package according to the first aspect. The transistor has an inner cavity, the inner cavity is configured to transmit a total light ray, the transistor outline package is mounted on the transistor, and the main lens transmits the total light ray towards the inner cavity.

In this solution, dimension reduction of packaging is performed at a component level, so that a single transistor outline package can combine at least two light rays. Therefore, when an optical sub-assembly is applied to a multi-channel receiving and sending scenario, a quantity of transistor outline packages requiring integration can be reduced, so that a structure of the optical sub-assembly is simpler, a manufacturing process is less difficult, costs are lower, and miniaturization packaging can be implemented.

According to a sixth aspect, this application further provides an optical module. The optical module includes an outline and the optical sub-assembly according to the fifth aspect, wherein the optical sub-assembly is mounted on the outline, the outline has an optical fiber port, and the optical fiber port is configured to connect to an optical fiber.

This solution helps reduce a volume of the optical module, implement miniaturization of the optical module, and further can reduce costs of the optical module.

According to a seventh aspect, this application further provides the production method for the optical module according to the sixth aspect. The production method includes: fastening the optical splitting component to the transistor base; presetting the first chip and the second chip on the transistor base; adjusting a position of the first chip based on a flare of the first light ray or an optical power of the first light ray, and fastening the first chip when the flare of the first light ray is located at a first preset position or the optical power of the first light ray reaches a first preset optical power; adjusting a position of the second chip based on a flare of the second light ray or an optical power of the second light ray, and fastening the second chip when the flare of the second light ray is located at a second preset position or the optical power of the second light ray reaches a second preset power; and mounting the transistor cap on the transistor base to form the transistor outline package; mounting the transistor outline package on the transistor to form the optical sub-assembly; and mounting the optical sub-assembly on an outline to form the optical module.

In this solution, the transistor outline package is actively assembled. The positions of the first chip and the second chip may be adjusted based on actual situations to ensure a coincidence degree between the first light ray and the second light ray. In this way, signal transmission accuracy of the optical module can be improved to improve working reliability of the optical module.

According to an eighth aspect, this application further provides another production method for the optical module according to the sixth aspect. The transistor outline package in the optical module includes a first lens and a second lens. The first lens is disposed between the first chip and the main lens and is configured to adjust a transmission direction of the first light ray. The second lens is disposed between the second chip and the main lens and is configured to adjust a transmission direction of the second light ray. The production method includes: fastening the optical splitting component, the first lens, and the second lens to the transistor base; presetting the first chip and the second chip on the transistor base; adjusting a position of the first chip based on a flare of the first light ray or an optical power of the first light ray, and fastening the first chip when the flare of the first light ray is located at a first preset position or the optical power of the first light ray reaches a first preset optical power; adjusting a position of the second chip based on a flare of the second light ray or a power of the second light ray, and fastening the second chip when the flare of the second light ray is located at a second preset position or the optical power of the second light ray reaches a second preset optical power; and mounting the transistor cap on the transistor base to form the transistor outline package; mounting the transistor outline package on the transistor to form the optical sub-assembly; and mounting the optical sub-assembly on an outline to form the optical module.

In this solution, the transistor outline package is actively assembled. The positions of the first chip and the second chip may be adjusted based on actual situations to ensure a coincidence degree between the first light ray and the second light ray. In this way, signal transmission accuracy of the optical module can be improved to improve working reliability of the optical module.

According to a ninth aspect, this application further provides another production method for the optical module according to the sixth aspect. The transistor outline package in the optical module includes a first lens and a second lens. The first lens is disposed between the first chip and the main lens and is configured to adjust a transmission direction of the first light ray. The second lens is disposed between the second chip and the main lens and is configured to adjust a transmission direction of the second light ray. The production method includes: fastening the optical splitting component, the first chip, and the second chip to the transistor base; presetting the first lens and the second lens on the transistor base; adjusting a position of the first lens based on a flare of the first light ray or an optical power of the first light ray, and fastening the first lens when the flare of the first light ray is located at a first preset position or the optical power of the first light ray reaches a first preset optical power; adjusting a position of the second lens based on a flare of the second light ray or an optical power of the second light ray, and fastening the second lens when the flare of the second light ray is located at a second preset position or the optical power of the second light ray reaches a second preset power; and mounting the transistor cap on the transistor base to form the transistor outline package; mounting the transistor outline package on the transistor to form the optical sub-assembly; and mounting the optical sub-assembly on an outline to form the optical module.

In this solution, the transistor outline package is actively assembled. The positions of the first lens and the second lens may be adjusted based on actual situations to ensure a coincidence degree between the first light ray and the second light ray. In this way, signal transmission accuracy of the optical module can be improved to improve working reliability of the optical module.

According to a tenth aspect, this application further provides an optical communication system. The optical communication system includes an optical line terminal and an optical network unit. The optical line terminal is connected to the optical network unit via a passive optical distribution network. The optical line terminal includes the optical sub-assembly according to the fifth aspect or the optical module according to the sixth aspect, or the optical network unit includes the optical sub-assembly according to the fifth aspect or the optical module according to the sixth aspect.

In this solution, a volume of the optical sub-assembly is relatively small, and costs are relatively low. This helps reduce a volume of the optical communication system and reduce costs of the optical communication system.

### BRIEF DESCRIPTION OF DRAWINGS

FIG. 1 is a schematic diagram of a structure of a transistor outline package according to an embodiment of this application;
FIG. 2 is a schematic diagram of another structure of a transistor outline package according to an embodiment of this application;
FIG. 3 is a schematic diagram of another structure of a transistor outline package according to an embodiment of this application;
FIG. 4 is a schematic diagram of another structure of a transistor outline package according to an embodiment of this application;
FIG. 5 is a schematic diagram of another structure of a transistor outline package according to an embodiment of this application;
FIG. 6 is a schematic diagram of another structure of a transistor outline package according to an embodiment of this application;
FIG. 7 is a schematic diagram of another structure of a transistor outline package according to an embodiment of this application;
FIG. 8 is a schematic diagram of another structure of a transistor outline package according to an embodiment of this application;
FIG. 9 is a schematic diagram of another structure of a transistor outline package according to an embodiment of this application;
FIG. 10 is a schematic diagram of another structure of a transistor outline package according to an embodiment of this application;
FIG. 11 is a schematic diagram of another structure of a transistor outline package according to an embodiment of this application;
FIG. 12 is a schematic diagram of another structure of a transistor outline package according to an embodiment of this application;
FIG. 13 is a schematic diagram of another structure of a transistor outline package according to an embodiment of this application;
FIG. 14 is a schematic diagram of another structure of a transistor outline package according to an embodiment of this application;
FIG. 15 is a schematic diagram of another structure of a transistor outline package according to an embodiment of this application;
FIG. 16 is a schematic diagram of another structure of a transistor outline package according to an embodiment of this application;
FIG. 17 is a schematic diagram of another structure of a transistor outline package according to an embodiment of this application;
FIG. 18 is a schematic diagram of another structure of a transistor outline package according to an embodiment of this application;
FIG. 19 is a schematic diagram of another structure of a transistor outline package according to an embodiment of this application;
FIG. 20 is a schematic diagram of another structure of a transistor outline package according to an embodiment of this application;
FIG. 21 is a schematic diagram of another structure of a transistor outline package according to an embodiment of this application;
FIG. 22 is a schematic diagram of another structure of a transistor outline package according to an embodiment of this application;
FIG. 23 is a schematic diagram of another structure of a transistor outline package according to an embodiment of this application;
FIG. 24 is a schematic diagram of another structure of a transistor outline package according to an embodiment of this application;
FIG. 25 is a schematic diagram of another structure of a transistor outline package according to an embodiment of this application;
FIG. 26 is a schematic diagram of another structure of a transistor outline package according to an embodiment of this application;
FIG. 27 is a schematic diagram of another structure of a transistor outline package according to an embodiment of this application;
FIG. 28 is a schematic diagram of another structure of a transistor outline package according to an embodiment of this application;
FIG. 29 is a schematic diagram of another structure of a transistor outline package according to an embodiment of this application;
FIG. 30 is a schematic diagram of another structure of a transistor outline package according to an embodiment of this application;
FIG. 31 is a schematic diagram of another structure of a transistor outline package according to an embodiment of this application;
FIG. 32 is a schematic sectional view of a structure of an optical sub-assembly according to an embodiment of this application;
FIG. 33 is a schematic sectional view of a structure of an optical sub-assembly according to a conventional technology;
FIG. 34 is a schematic sectional view of another structure of an optical sub-assembly according to an embodiment of this application;
FIG. 35 is a schematic diagram of a structure of an optical communication system according to an embodiment of this application;
FIG. 36 is a schematic diagram of a production procedure of a transistor outline package according to an embodiment of this application;
FIG. 37 is a schematic diagram of another production procedure of a transistor outline package according to an embodiment of this application; and
FIG. 38 is a schematic diagram of another production procedure of a transistor outline package according to an embodiment of this application.

### Reference numerals:

1-transistor base;
2-transistor cap;
3-main lens;
4-first chip;
5-second chip;
6-optical splitting component;
7-first lens;
8-second lens;
9-substrate;
91-first side face;
92-second side face;
93-first surface;
10-third chip;
11-fourth chip;
12-temperature control apparatus;
A-total light ray;
A1-first light ray;
A2-second light ray;
A3-third light ray;
A4-fourth light ray;
110-transistor outline package;
120-transistor;
140-first transistor outline package;
150-second transistor outline package;
160-third transistor outline package;
170-fourth transistor outline package;
180-fifth transistor outline package;
100-optical sub-assembly;
200-optical line terminal;
300-optical network unit; and
400-passive optical distribution network.

### DESCRIPTION OF EMBODIMENTS

For ease of understanding of a transistor outline package and a production method thereof, an optical sub-assembly, an optical module, and an optical communication system that are provided in embodiments of this application, the following describes application scenarios thereof. With development of technologies, applications of implementing signal transmission by using an optical signal are increasingly wide. For example, an optical module product is applied in fields such as a passive optical network (PON), a wireless network, and an internet protocol (IP). The optical module usually includes the optical sub-assembly, and the optical sub-assembly further includes a packaging structure. For example, a currently widely used packaging structure with relatively low costs is a transistor outline package (which may be specifically a coaxial-type package). An optical receiver chip or an optical transmitter chip and an original part such as a lens group are packaged into an integrated structure to form a transistor outline (TO) package, facilitating production and formation of the optical sub-assembly. In a conventional technology, the transistor outline package can usually package only one chip, in other words, the transistor outline package can transmit only one optical transmit signal or optical receive signal. Currently, the optical sub-assembly needs to have a multi-direction transmission function, so as to reduce a volume of an optical module and enrich functions of the optical module. In a conventional technology, to implement the multi-direction transmission function of the optical sub-assembly, a plurality of transistor outline packages need to be assembled for the optical sub-assembly. Consequently, an optical path design of the optical sub-assembly is relatively complex, and a manufacturing difficulty is increased. In addition to relatively high costs, a total volume of the optical sub-assembly is also relatively large. Therefore, this application provides a transistor outline package that can be integrated with two receiving components and a production method thereof, and an optical sub-assembly, an optical module, and an optical communication system that have the foregoing transistor outline package. The following describes in detail the embodiments of this application with reference to the accompanying drawings.

The terms used in the following embodiments are merely intended to describe specific embodiments, but are not intended to limit this application. The terms "one", "a" and "this" of singular forms used in this specification and the appended claims of this application are also intended to include expressions such as "one or more", unless otherwise specified in the context clearly.

Reference to "an embodiment", "a specific embodiment", or the like described in this specification indicates that one or more embodiments of this application include a specific feature, structure, or characteristic described with reference to the embodiment. The terms "include", "contain", "have", and their variants all mean "include but are not limited to", unless otherwise specifically emphasized in another manner.

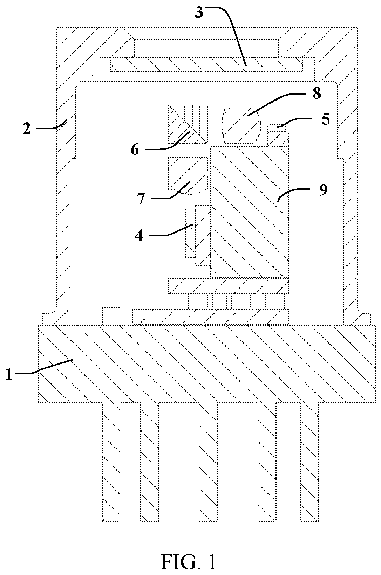

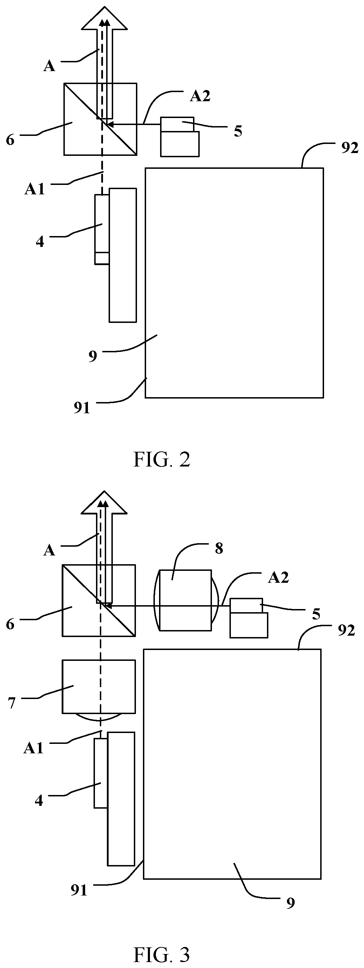

FIG. 1 is a schematic sectional view of a structure of a transistor outline package according to an embodiment of this application. FIG. 2 is a schematic diagram of a structure of a transistor outline package according to an embodiment of this application. As shown in FIG. 1 and FIG. 2, the transistor outline (TO) package in this embodiment of this application includes a transistor base 1, a transistor cap 2, a main lens 3, a first chip 4, a second chip 5, and an optical splitting component 6. The transistor cap 2 is disposed on the transistor base 1, so that the transistor cap 2 and the transistor base 1 form an accommodation cavity. The main lens 3 is disposed on a top of the transistor cap 2 and runs through the transistor cap 2, so that a light ray can be transmitted inside and outside the accommodation cavity through the main lens 3. The main lens 3 is configured to transmit a total light ray A. The total light ray A is all light rays transmitted by the transistor outline package, and may specifically include a first light ray A1 and a second light ray A2. The first chip 4 is disposed in the accommodation cavity, and may be specifically mounted on the transistor base 1. The first light ray A1 is transmitted between the first chip 4 and the main lens 3. Similarly, the second chip 5 is also disposed in the accommodation cavity, and may also be mounted on the transistor base 1. The second light ray A2 is transmitted between the second chip 5 and the main lens 3. The optical splitting component 6 is disposed between the first chip 4 and the main lens 3, and is located between the second chip 5 and the main lens 3. Therefore, a transmission direction of the first light ray A1 and a transmission direction of the second light ray A2 are adjusted by using the optical splitting component 6. In this way, the first light ray A1 is transmitted between the main lens 3, the optical splitting component 6, and the first chip 4, and the second light ray A2 is transmitted between the main lens 3, the optical splitting component 6, and the second chip 5, so that the first light ray A1 and the second light ray A2 can be transmitted respectively corresponding to the first chip 4 and the second chip 5, and can be aggregated into the total light ray A for transmission through the main lens 3. Specifically, wavelengths of the first light ray A1 and the second light ray A2 are different, so that the first light ray A1 and the second light ray A2 can be split into two parts by using the optical splitting component 6 on a side of the optical splitting component 6 towards the first chip 4 and the second chip 5, and can be aggregated into the total light ray A on a side of the optical splitting component 6 towards the main lens 3, to implement wavelength division multiplexing. Therefore, the foregoing transistor outline package can be integrated with at least two chips, and all light rays of the transistor outline package are transmitted by using one main lens 3. In this case, the transistor outline package can transmit at least two signals to improve integration of the transistor outline package.

In a conventional technical solution, if the optical sub-assembly needs to implement multi-channel receiving and sending of an optical signal and integrate with a plurality of transistor outline packages having a single receiving function or a single sending function, a large quantity of transistor outline packages are required, and complex design of an optical path related to light splitting, multiplexing, and coupling needs to be performed. Therefore, a design difficulty is high, a quantity of elements is large, and a volume of the optical sub-assembly is relatively large. In addition, requirements for process precision and devices are high, and production efficiency is low due to many processes. In this solution, dimension reduction of packaging is performed at a component level, so that a single transistor outline package can transmit at least two signals. Therefore, when the optical sub-assembly is applied to a multi-channel receiving and sending scenario, a quantity of transistor outline packages requiring integration can be reduced, so that a structure of the optical sub-assembly is simpler, a manufacturing process is less difficult, costs are lower, and miniaturization packaging can be implemented.

In this embodiment of this application, the optical splitting component 6 is used inside the transistor outline package for optical splitting, simplifying a complex design of performing multi-wavelength optical splitting in a transistor outline of the optical sub-assembly, saving space of the optical sub-assembly, and reducing quantities of external lenses and external optical filters of the optical sub-assembly. In addition, in the technical solution in this application, after a quantity of receiving transistor outline packages included in the optical sub-assembly is reduced, the volume of the optical sub-assembly is smaller. Therefore, an optical path for transmitting a light ray in the optical sub-assembly can be shortened. Therefore, all transistor outline packages can use a design of the transistor cap 2. Compared with a conventional optical path combination solution of parallel light or relay lenses, a large quantity of external collimating lenses or relay lenses are saved, and a packaging size of a component is reduced. In addition, an optical path of a transistor outline package of each terminal is independently coupled, and a coupling process is simpler. This solution saves a plurality of processes of surface mounting, adhesive sticking, and coupling at a component level, reduces an overall processing difficulty, and improves production efficiency.

In a specific embodiment, the main lens 3 may be a planar lens or a collimating lens. This is not limited in this application.

FIG. 3 is a schematic diagram of another structure of a transistor outline package according to an embodiment of this application. As shown in FIG. 3, in another embodiment, the foregoing transistor outline package further includes a first lens 7 and a second lens 8. The first lens 7 is disposed between the first chip 4 and the main lens 3, and is configured to collimate the first light ray A1. The second lens 8 is disposed between the second chip 5 and the main lens 3, and is configured to collimate the second light ray A2. In this solution, by disposing the first lens 7, a transmission path of the first light ray A1 can be more accurate, and the first light ray A1 can be collimated between the main lens 3 and the first chip 4 once, improving accuracy of a signal corresponding to the first light ray A1. Similarly, by disposing the second lens 8, a transmission path of the second light ray A2 can be more accurate, and the second light ray A2 can be collimated between the main lens 3 and the second chip 5 once, improving accuracy of a signal corresponding to the second light ray A2. This solution can improve a parallelism degree and a coincidence degree between first light ray A1 and the second light ray A2.

In another embodiment, the first lens 7 may further be configured to converge the first light ray A1, and the second lens 8 is configured to converge the second light ray A2. In this solution, a focus of the first light ray A1 may be adjusted by using the first lens 7, and a focus of the second light ray A2 may be adjusted by using the second lens 8, so that the focus of the first light ray A1 coincides with the focus of the second light ray A2.

When the first lens 7 and the second lens 8 are specifically disposed, as shown in FIG. 3, the first lens 7 and the second lens 8 may be of a separated structure, so that a position of the first lens 7 is adjusted based on a positional relationship between the first chip 4, the optical splitting component 6, and the main lens 3, and a position of the second lens 8 is adjusted based on a positional relationship between the second chip 5, the optical splitting component 6, and the main lens 3, to improve accuracy of the transmission paths of the first light ray A1 and the second light ray A2.

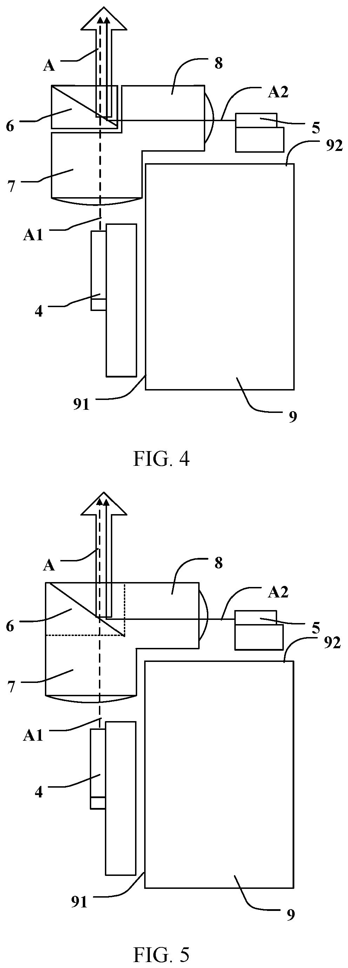

FIG. 4 is a schematic diagram of another structure of a transistor outline package according to an embodiment of this application. As shown in FIG. 4, in another embodiment, the first lens 7 and the second lens 8 may alternatively be of an integrated structure. This solution can reduce a quantity of accessories of the transistor outline package, facilitate manufacturing and assembly of the first lens 7 and the second lens 8, and help reduce a volume of the transistor outline package.

FIG. 5 is a schematic diagram of another structure of a transistor outline package according to an embodiment of this application. As shown in FIG. 5, in still another embodiment, the first lens 7, the second lens 8, and the optical splitting component 6 may alternatively be of an integrated structure. This embodiment can further reduce the quantity of accessories of the transistor outline package, facilitates simplification of an assembly process of the transistor outline package, and also help reduce the volume of the transistor outline package.

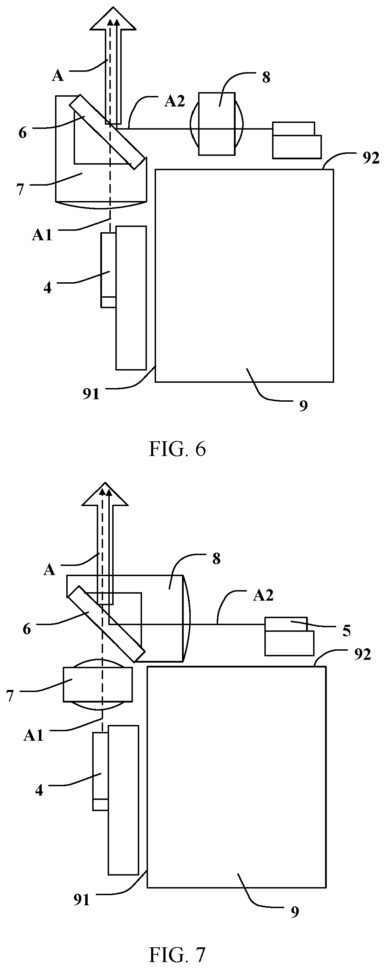

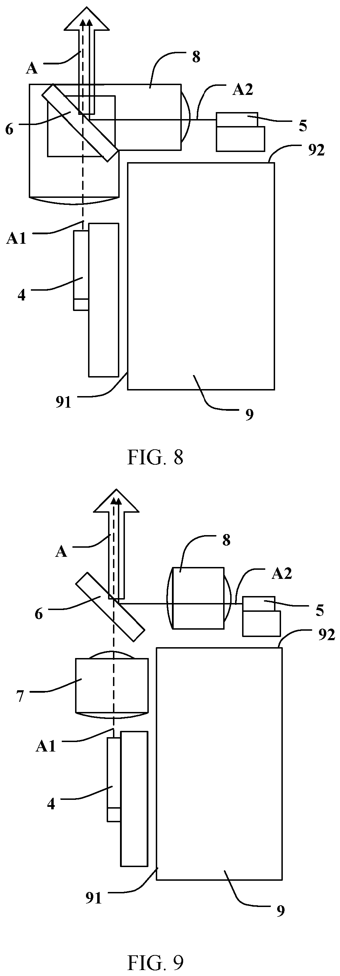

In addition, when the optical splitting component 6 is specifically mounted, the optical splitting component 6 may be directly mounted on the transistor base 1. FIG. 6 is a schematic diagram of another structure of a transistor outline package according to an embodiment of this application. As shown in FIG. 6, the optical splitting component 6 may be mounted on the first lens 7. As shown in FIG. 6, the first lens 7 may have a mounting bracket, and the optical splitting component 6 is mounted on the first lens 7 via the mounting bracket. Alternatively, FIG. 7 is a schematic diagram of another structure of a transistor outline package according to an embodiment of this application. As shown in FIG. 7, the optical splitting component 6 may be mounted on the second lens 8. As shown in FIG. 7, the second lens 8 may have a mounting bracket, and the optical splitting component 6 is mounted on the second lens 8 via the mounting bracket. FIG. 8 is a schematic diagram of another structure of a transistor outline package according to an embodiment of this application. As shown in FIG. 8, when the first lens 7 and the second lens 8 are of an integrated structure, the first lens 7 and the second lens 8 that are integrated may have a mounting bracket. As shown in FIG. 8, the optical splitting component 6 is mounted on the first lens 7 and the second lens 8 via the mounting bracket. This application can reduce a quantity of mechanical parts used by the base to mount components. In addition, the optical splitting component 6 is located between the main lens 3, the first lens 7, and the second lens 8. If a mechanical part is involved, the mechanical part is relatively complex. However, in this application, the optical splitting component 6 is directly mounted on the first lens 7 or the second lens 8. This helps reduce a volume of the transistor outline package. In addition, the optical splitting component 6 in this solution is in a mounting relationship with the first lens 7 and the second lens 8. Therefore, before mounting, it is convenient to adjust a position to improve accuracy of transmission paths of the first light ray A1 and the second light ray A2.

In a specific embodiment, a positional relationship between the first chip 4 and the second chip 5 is not limited, in other words, transmission directions of the first light ray A1 between the optical splitting component 6 and the first chip 4 and the second light ray A2 between the optical splitting component 6 and the second chip 5 are not limited. The following lists several possible embodiments.

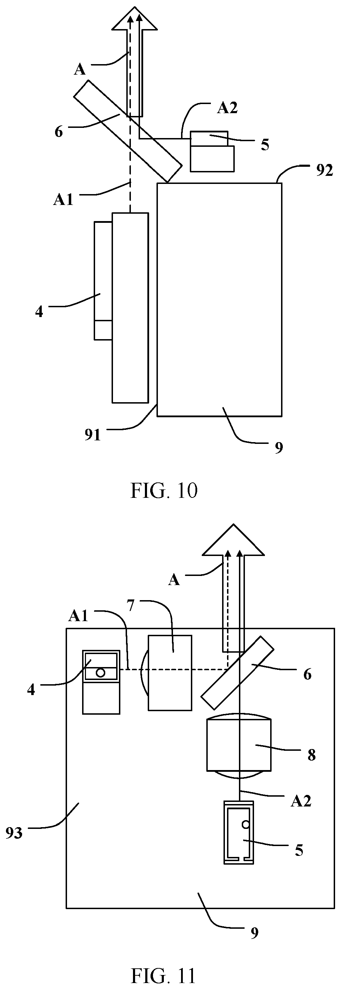

FIG. 9 and FIG. 10 are schematic diagrams of other two structures of a transistor outline package according to an embodiment of this application. In the embodiments shown in FIG. 2 to FIG. 10, the transistor outline package includes a substrate 9. The substrate 9 includes a first side face 91 and a second side face 92. The first side face 91 is perpendicular to the second side face 92. The first chip 4 is disposed on the first side face 91, the second chip 5 is disposed on the second side face 92, and the first light ray A1 between the optical splitting component 6 and the first chip 4 is perpendicular to the second light ray A2 between the optical splitting component 6 and the second chip 5.

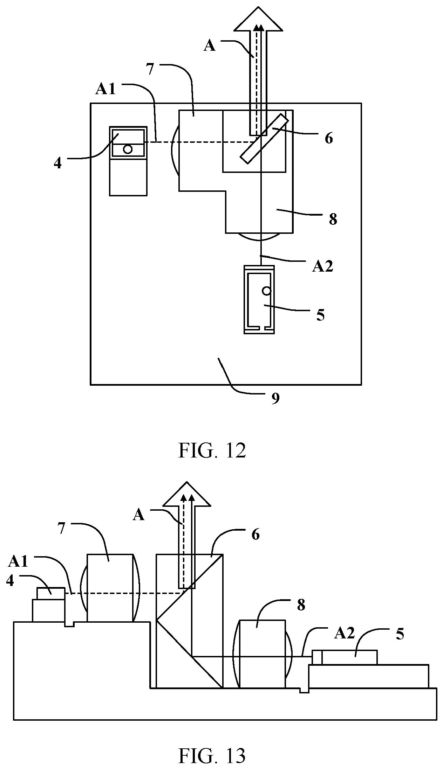

FIG. 11 and FIG. 12 are schematic diagrams of other two structures of a transistor outline package according to an embodiment of this application. As shown in FIG. 11 and FIG. 12, in another possible embodiment, the substrate 9 further includes a first surface 93. The first surface 93 is usually a surface with a relatively large area of the substrate 9. Both the first chip 4 and the second chip 5 are disposed on the first surface 93, that is, the first chip 4 and the second chip 5 are disposed on the same surface. However, the first light ray A1 between the optical splitting component 6 and the first chip 4 is perpendicular to the second light ray A2 between the optical splitting component 6 and the second chip 5.

It should be noted that "perpendicular" in the embodiments of this application is a current process level, but is not an absolute strict definition in a mathematical sense. A deviation of a predetermined angle may exist between the first light ray A1 and the second light ray A2. To be specific, an angle between the first light ray A1 and the second light ray A2 is not necessarily 90° strictly, and may be 85°, 86°, 87°, 88°, 89°, 91°, 92°, 93°, 94°, 95°, or the like.

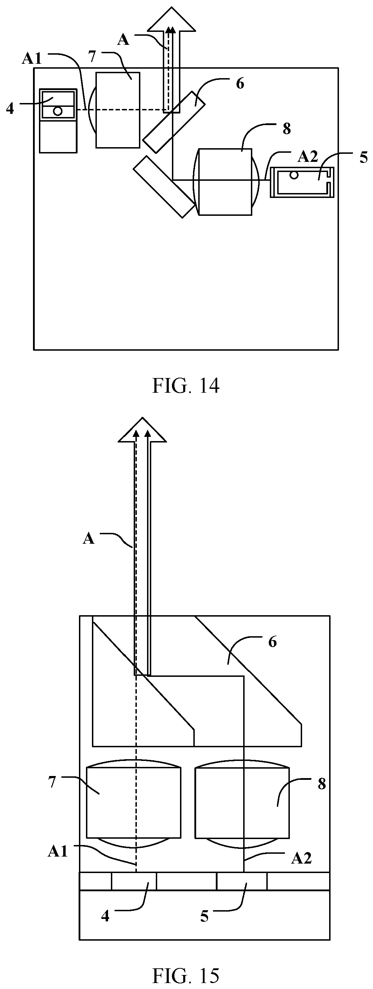

FIG. 13 and FIG. 14 are schematic diagrams of other two structures of a transistor outline package according to an embodiment of this application. As shown in FIG. 13 and FIG. 14, in another possible embodiment, the first chip 4 and the second chip 5 are disposed on two opposite sides of the optical splitting component 6, but the first chip 4 and the second chip 5 are not necessarily disposed on a same straight line. The first light ray A1 between the optical splitting component 6 and the first chip 4 may be parallel to the second light ray A2 between the optical splitting component 6 and the second chip 5. In addition, the first light ray A1 and the second light ray A2 (the total light ray A) between the optical splitting component 6 and the main lens 3 may be perpendicular to the first light ray A1 between the optical splitting component 6 and the first chip 4, and perpendicular to the second light ray A2 between the optical splitting component 6 and the second chip 5. As shown in FIG. 13, to mount the foregoing structures, the transistor outline package may include mechanical parts, configured to mount the first chip 4, the second chip 5, the first lens 7, the second lens 8, and the optical splitting component 6.

It should be noted that "parallel" in the embodiments of this application is a current process level, but is not an absolute strict definition in a mathematical sense. A deviation of a predetermined angle may exist between the first light ray A1 and the second light ray A2. To be specific, an angle between the first light ray A1 and the second light ray A2 is not necessarily 0° or 180° strictly. For example, an acute angle between the first light ray A1 and the second light ray A2 may be 0.5°, 1°, 1.5°, 2°, 3°, 4°, 4.5°, or 5°.

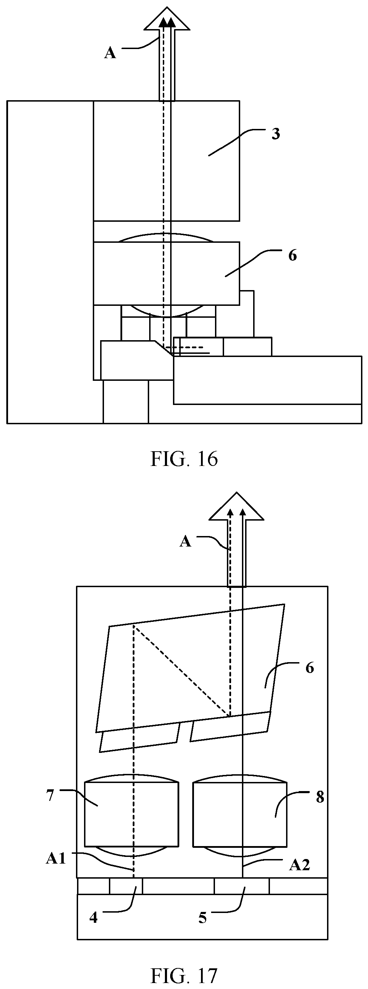

FIG. 15 is a schematic diagram of another structure of a transistor outline package according to an embodiment of this application. FIG. 16 is a schematic side view of a structure of a transistor outline package according to an embodiment of this application. As shown in FIG. 15 and FIG. 16, in another possible embodiment, the first chip 4 and the second chip 5 are disposed on a same side of the optical splitting component 6, but the first chip 4 and the second chip 5 may be disposed on a same plane or different planes. The first light ray A1 between the optical splitting component 6 and the first chip 4 may be parallel to the second light ray A2 between the optical splitting component 6 and the second chip 5. In addition, the first light ray A1 and the second light ray A2 (the total light ray A) between the optical splitting component 6 and the main lens 3 may be parallel to the first light ray A1 between the optical splitting component 6 and the first chip 4, and parallel to the second light ray A2 between the optical splitting component 6 and the second chip 5.

The first chip 4 and the second chip 5 may be disposed on a same plane, for example, in the embodiments shown in FIG. 11, FIG. 12, FIG. 15, and FIG. 16. When the first chip 4 and the second chip 5 are disposed on a same plane, a tolerance between a mounting plane of the first chip 4 and a mounting plane of the second chip 5 is reduced, and positions of the first chip 4 and the second chip 5 are conveniently adjusted, so that a coincidence degree between the total light ray A of the first light ray A1 and the second light ray A2 between the optical splitting component 6 and the main lens 3 is higher.

In a specific embodiment, a specific structure of the optical splitting component 6 is not limited, provided that the transmission direction of the first light ray A1 and the transmission direction of the second light ray A2 can be adjusted. Specifically, the first light ray A1 and the second light ray A2 are transmitted in a same direction on a side of the optical splitting component 6 towards the main lens 3, and the first light ray A1 and the second light ray A2 are transmitted in different directions on a side of the optical splitting component 6 away from the main lens 3. For example, the optical splitting component 6 includes at least one of an optical filter, an optical splitter (ODeMUX), a planar lightwave, the light splitting prism (PBS), or a rhomboid prism optical splitter (Block). Specifically, the light splitting prism may specifically perform light splitting by using a polarization principle or by using a wavelength division multiplexing principle. This is not limited in this application.

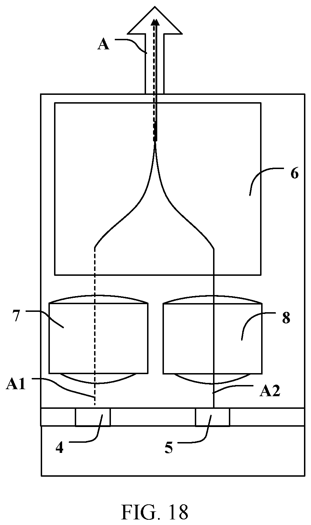

For example, in the embodiments shown in FIG. 2 to FIG. 5, FIG. 13, FIG. 15, and FIG. 16, the optical splitting component 6 is a light splitting prism; in the embodiments shown in FIG. 6 to FIG. 12 and FIG. 14, the optical splitting component 6 is an optical filter; and in the embodiment shown in FIG. 14, the optical splitting component 6 includes two optical filters. FIG. 17 is a schematic diagram of another structure of a transistor outline package according to an embodiment of this application. As shown in FIG. 17, in another possible embodiment, the optical splitting component 6 may further include a combination of a rhomboid prism optical splitter and an optical filter. Possible transmission paths of the first light ray A1 and the second light ray A2 are shown in FIG. 17. Specifically, the optical splitting component 6 includes one rhomboid prism optical splitter and two optical filters. The two optical filters respectively correspond to the first chip 4 and the second chip 5. The rhomboid prism optical splitter is disposed on a side of the optical filter away from the first chip 4 and the second chip 5, and a side of the rhomboid prism optical splitter away from the optical filter is provided with a reflective film to implement a function of the optical splitting component 6. FIG. 18 is a schematic diagram of another structure of a transistor outline package according to an embodiment of this application. As shown in FIG. 18, in another possible embodiment, the optical splitting component 6 may alternatively be a planar lightwave. In the embodiment shown in FIG. 18, the planar lightwave may combine two light rays into one total light ray A.

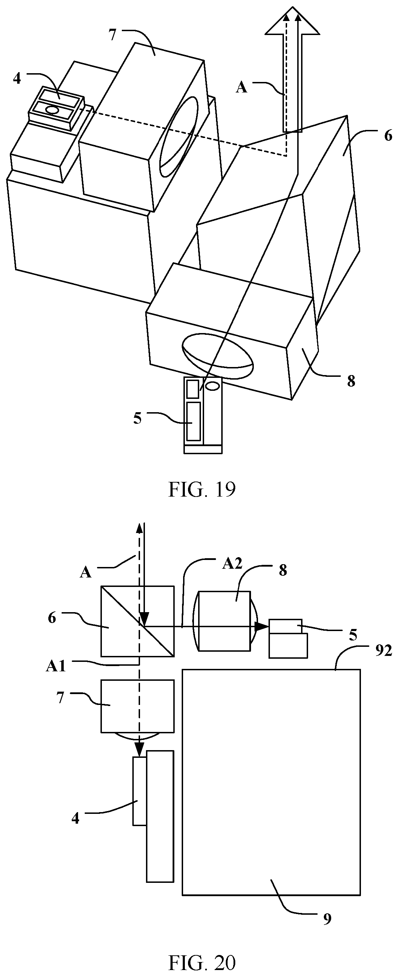

FIG. 19 is a schematic diagram of another structure of a transistor outline package according to an embodiment of this application. As shown in FIG. 19, in another possible embodiment, the optical splitting component 6 may further include at least two light splitting prisms, or may cooperate with another optical splitting component by using the light splitting prism. In this way, the positional relationship between the first chip 4 and the second chip 5 may be irregular, in other words, a shape and a combination manner of the optical splitting component 6 may be designed based on actual positions of the first chip 4 and the second chip 5. This is not limited in this application.

In a specific embodiment, as shown in the embodiments shown in FIG. 2 to FIG. 18, the first chip 4 is an optical transmitter chip, and the second chip 5 is also an optical transmitter chip, that is, the transistor outline package is at least a transistor outline package integrated with two sending components. Specifically, the first light ray A1 is emitted from the first chip 4, and the second light ray A2 is emitted from the second chip 5. After being adjusted by the optical splitting component 6, the first light ray A1 and the second light ray A2 are converged into the total light ray A, which is emitted from the main lens 3.

FIG. 20 is a schematic diagram of another structure of a transistor outline package according to an embodiment of this application. As shown in FIG. 20, in another possible embodiment, the first chip 4 is an optical transmitter chip, and the second chip 5 is an optical receiver chip, that is, the transistor outline package is at least a transistor outline package integrated with a sending component and a receiving component. The first light ray A1 is emitted from the first chip 4, then is adjusted by the optical splitting component 6, and is emitted in the direction of the total light ray A. The total light ray A further receives the second light ray A2, is emitted to the second chip 5 after being adjusted by the optical splitting component 6, and is received by the second chip 5.

In a specific embodiment, the optical transmitter chip in this application may be a laser chip (LD), and the optical receiver chip may be a Photo diode (PD).

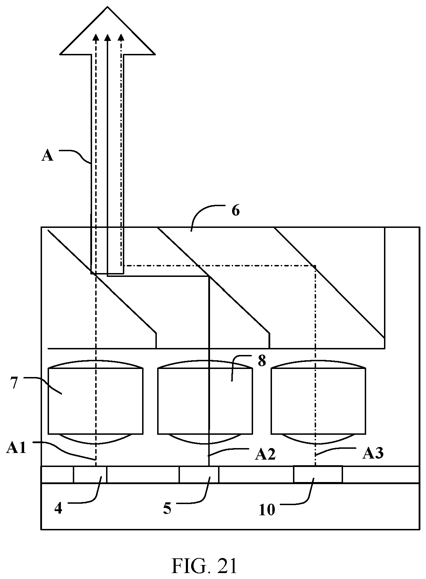

FIG. 21 is a schematic diagram of another structure of a transistor outline package according to an embodiment of this application. As shown in FIG. 21, in another possible embodiment, the transistor outline package may further include a third chip 10. The third chip 10 is also disposed in the accommodation cavity. The total light ray A further includes a third light ray A3. The third light ray A3 is transmitted between the third chip 10 and the main lens 3. The optical splitting component 6 is further disposed between the main lens 3 and the third chip 10 and is configured to adjust a transmission direction of the third light ray A3, so that the third light ray A3, the first light ray A1, and the second light ray A2 can be combined into the total light ray A on a side of the optical splitting component 6 towards the main lens 3, in other words, the transmission directions are the same. This solution can further improve integration of the transistor outline package, and help reduce the volume of the optical sub-assembly.

In this embodiment of this application, at least three light rays can be integrated. For example, in the embodiment shown in FIG. 21, the first chip 4, the second chip 5, and the third chip 10 are optical transmitter chips. Therefore, a transistor outline package integrated with three sending components can be implemented. Certainly, in other embodiments, the first chip 4 and the second chip 5 may be optical transmitter chips, and the third chip 10 may be an optical receiver chip, so that a transistor outline package integrated with two sending components and one receiving component can be implemented; or the first chip 4 may be an optical transmitter chip, and the second chip 5 and the third chip 10 may be optical receiver chips, so that a transistor outline package integrated with one sending component and two receiving components can be implemented. Cases are not enumerated one by one in this application.

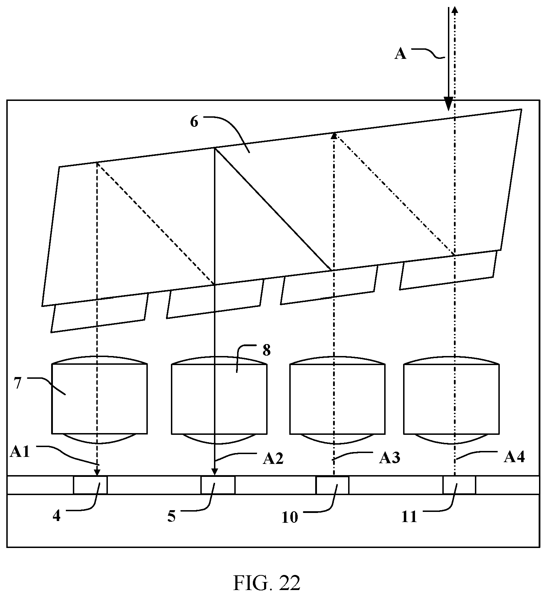

FIG. 22 is a schematic diagram of another structure of a transistor outline package according to an embodiment of this application. As shown in FIG. 22, in another possible embodiment, the transistor outline package may further include a fourth chip 11. The fourth chip 11 is also disposed in the accommodation cavity. The total light ray A further includes a fourth light ray A4. The fourth light ray A4 is transmitted between the fourth chip 11 and the main lens 3. The optical splitting component 6 is further disposed between the main lens 3 and the fourth chip 11 and is configured to adjust a transmission direction of the fourth light ray A4, so that the fourth light ray A4, the third light ray A3, the first light ray A1, and the second light ray A2 can be combined into the total light ray A on a side of the optical splitting component 6 towards the main lens 3, in other words, the transmission directions are the same. This solution can further improve integration of the transistor outline package, and help reduce the volume of the optical sub-assembly.

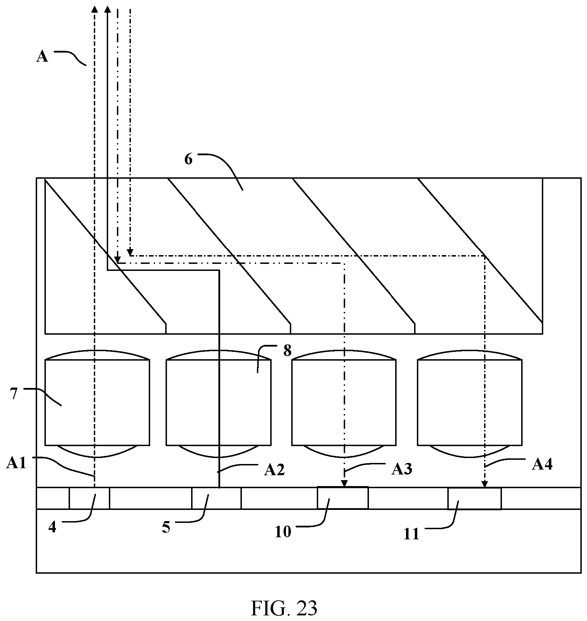

In this embodiment of this application, at least four light rays can be integrated. For example, in the embodiment shown in FIG. 22, the first chip 4, the second chip 5, the third chip 10, and the fourth chip 11 are optical transmitter chips. Therefore, a transistor outline package integrated with four sending components can be implemented. Certainly, in another embodiment, as shown in FIG. 23, the first chip 4 and the second chip 5 may be optical transmitter chips, and the third chip 10 and the fourth chip 11 may be optical receiver chips, so that a transistor outline package integrated with two sending components and two receiving components can be implemented. Alternatively, the first chip 4 may be an optical transmitter chip, and the second chip 5, the third chip 10, and the fourth chip 11 may be optical receiver chips, so that a transistor outline package integrated with one sending component and three receiving components can be implemented. Alternatively, the first chip 4, the second chip 5, and the third chip 10 may be optical transmitter chips, the fourth chip 11 may be an optical receiver chip, so that a transistor outline package integrated with three sending components and one receiving component can be implemented. Cases are not enumerated one by one in this application.

In another embodiment, the transistor outline package may further include five or more chips. Cases are not enumerated one by one herein.

FIG. 1 to FIG. 23 show only some embodiments of this application. The characteristics in the foregoing embodiments may be combined to obtain a new embodiment. Several specific embodiments are listed below with reference to the accompanying drawings. Certainly, the following embodiments are also some but not all of the embodiments of this application.

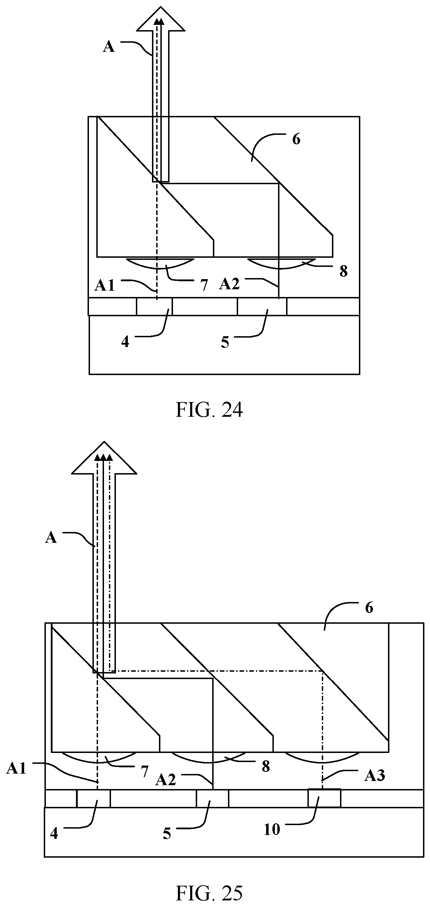

FIG. 24 is a schematic diagram of another structure of a transistor outline package according to an embodiment of this application. As shown in FIG. 24, in another specific embodiment, the transistor outline package includes a first chip 4 and a second chip 5. A first chip 4 and a second chip 5 are optical transmitter chips, and the first chip 4 and the second chip 5 are located on a same side of an optical splitting component 6. A first light ray A1 is parallel to a second light ray A2. The optical splitting component 6 is a light splitting prism, and the optical splitting component 6, a first lens 7, and a second lens 8 are of an integrated structure.

FIG. 25 is a schematic diagram of another structure of a transistor outline package according to an embodiment of this application. As shown in FIG. 25, in another specific embodiment, the transistor outline package includes a first chip 4, a second chip 5, and a third chip 10. The first chip 4, the second chip 5, and the third chip 10 are optical transmitter chips, and the first chip 4, the second chip 5, and the third chip 10 are located on a same side of an optical splitting component 6. A first light ray A1, a second light ray A2, and a third light ray A3 are parallel. The optical splitting component 6 is a light splitting prism, and the optical splitting component 6, a first lens 7, a second lens 8, and a third lens are of an integrated structure.

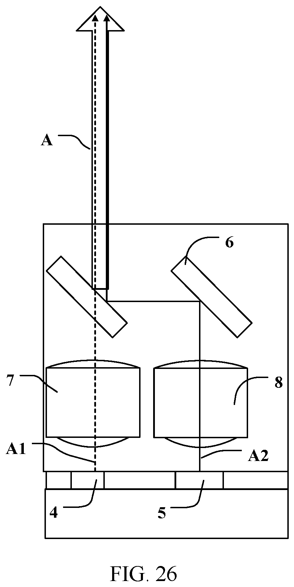

FIG. 26 is a schematic diagram of another structure of a transistor outline package according to an embodiment of this application. As shown in FIG. 26, in another specific embodiment, the transistor outline package includes a first chip 4 and a second chip 5. The first chip 4 and the second chip 5 are optical transmitter chips, and the first chip 4 and the second chip 5 are located on a same side of optical splitting components 6. A first light ray A1 is parallel to a second light ray A2. The optical splitting components 6 are two optical filters. The two optical filters are respectively opposite to the first chip 4 and the second chip 5, and are respectively configured to adjust a transmission direction of the first light ray A1 and a transmission direction of the second light ray A2.

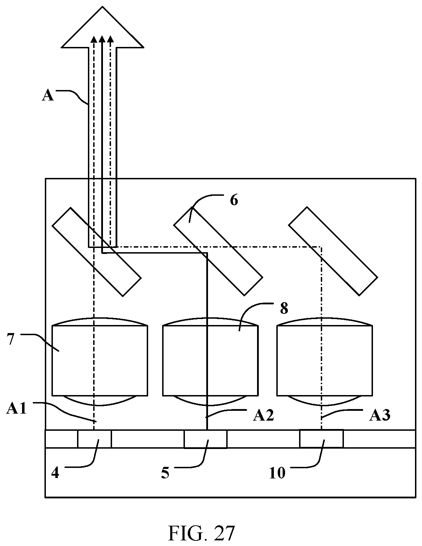

FIG. 27 is a schematic diagram of another structure of a transistor outline package according to an embodiment of this application. As shown in FIG. 27, in another specific embodiment, the transistor outline package includes a first chip 4, a second chip 5, and a third chip 10. The first chip 4, the second chip 5, and the third chip 10 are optical transmitter chips, and the first chip 4, the second chip 5, and the third chip 10 are located on a same side of optical splitting components 6. A first light ray A1, a second light ray A2, and a third light ray A3 are parallel. The optical splitting components 6 are three optical filters. The three optical filters are respectively opposite to the first chip 4, the second chip 5, and the third chip 10, and are respectively configured to adjust a transmission direction of the first light ray A1, a transmission direction of the second light ray A2, and a transmission direction of the third light ray A3.

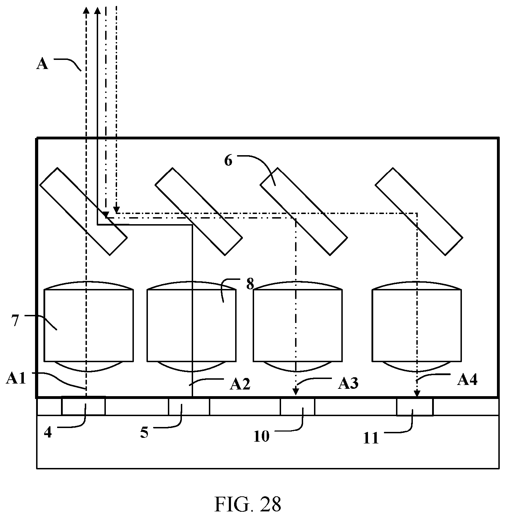

FIG. 28 is a schematic diagram of another structure of a transistor outline package according to an embodiment of this application. As shown in FIG. 28, in another specific embodiment, the transistor outline package includes a first chip 4, a second chip 5, a third chip 10, and a fourth chip 11. The first chip 4 and the second chip 5 are optical transmitter chips. The third chip 10 and the fourth chip 11 are optical receiver chips. The first chip 4, the second chip 5, the third chip 10, and the fourth chip 11 are located on a same side of optical splitting components 6. A first light ray A1, a second light ray A2, a third light ray A3, and a fourth light ray A4 are parallel. The optical splitting components 6 are four optical filters. The four optical filters are respectively opposite to the first chip 4, the second chip 5, the third chip 10, and the fourth chip 11, and are respectively configured to adjust a transmission direction of the first light ray A1, a transmission direction of the second light ray A2, a transmission direction of the third light ray A3, and a transmission direction of the fourth light ray A4.

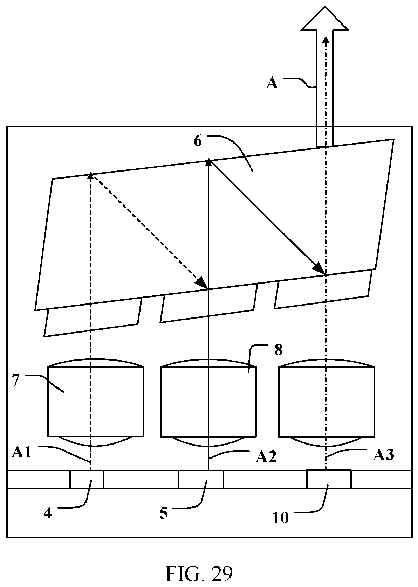

FIG. 29 is a schematic diagram of another structure of a transistor outline package according to an embodiment of this application. As shown in FIG. 29, in another specific embodiment, the transistor outline package includes a first chip 4, a second chip 5, and a third chip 10. The first chip 4, the second chip 5, and the third chip 10 are optical transmitter chips, and the first chip 4, the second chip 5, and the third chip 10 are located on a same side of optical splitting components 6. A first light ray A1, a second light ray A2, and a third light ray A3 are parallel. The optical splitting components 6 are three optical filters and one rhomboid prism optical splitter 6. The three optical filters are located on a side of the rhomboid prism optical splitter 6 towards the first chip 4, and the three optical filters are respectively opposite to the first chip 4, the second chip 5, and the third chip 10. The rhomboid prism optical splitter 6 cooperates with the three optical filters, and is configured to adjust a transmission direction of the first light ray A1, a transmission direction of the second light ray A2, and a transmission direction of the third light ray A3.

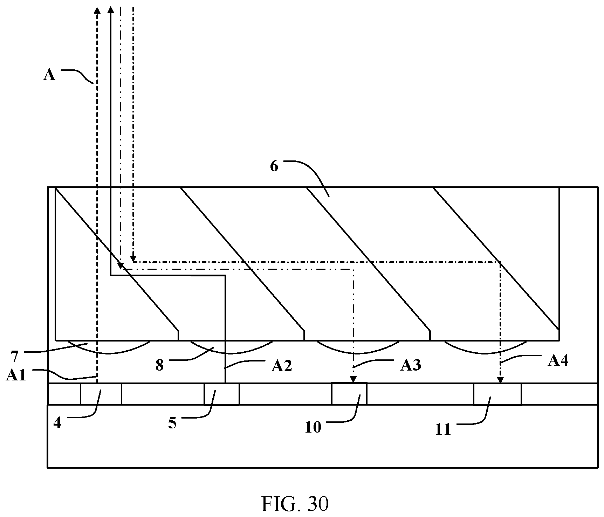

FIG. 30 is a schematic diagram of another structure of a transistor outline package according to an embodiment of this application. As shown in FIG. 30, in another specific embodiment, the transistor outline package includes a first chip 4, a second chip 5, a third chip 10, and a fourth chip 11. The first chip 4 and the second chip 5 are optical transmitter chips. The third chip 10 and the fourth chip 11 are optical receiver chips. The first chip 4, the second chip 5, the third chip 10, and the fourth chip 11 are located on a same side of an optical splitting component 6. A first light ray A1, a second light ray A2, a third light ray A3, and a fourth light ray A4 are parallel. The optical splitting component 6 is a light splitting prism. The light splitting prism is configured to adjust a transmission direction of the first light ray A1, a transmission direction of the second light ray A2, a transmission direction of the third light ray A3, and a transmission direction of the fourth light ray A4. In addition, in this embodiment, the light splitting prism, a first lens 7, a second lens 8, a third lens, and a fourth lens are of an integrated structure, implementing a transistor outline package, in which four light rays are combined, with a small volume.

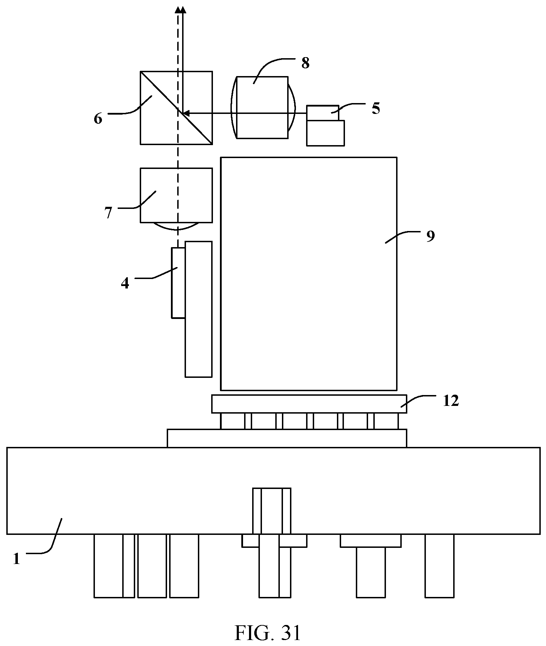

FIG. 31 is a schematic diagram of another structure of a transistor outline package according to an embodiment of this application. As shown in FIG. 31, in another specific embodiment, the transistor outline package further includes a temperature control apparatus 12. The temperature control apparatus 12 is configured to control temperatures of the first chip 4 and the second chip 5, so that the first chip 4 and the second chip 5 work within a proper temperature range to improve working stability of the chip and working performance of the chip. In a specific embodiment, the temperature control apparatus 12 may be a semiconductor cooler (TEC).

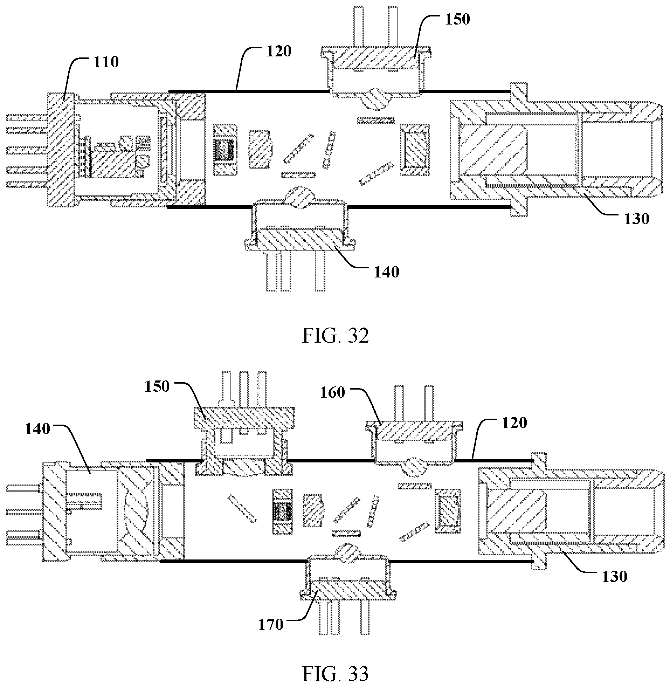

Based on a same inventive concept, this application further provides an optical sub-assembly. FIG. 32 is a schematic sectional view of a structure of an optical sub-assembly according to an embodiment of this application. As shown in FIG. 32, the optical sub-assembly includes a transistor 120 and at least one transistor outline package 110 according to any one of the foregoing embodiments. The transistor 120 has a transistor wall and an inner cavity. The transistor outline package 110 is mounted on the transistor wall of the transistor 120, and a main lens 3 of the transistor outline package 110 is disposed towards the inner cavity. The inner cavity of the transistor 120 is configured to transmit a total light ray A, in other words, an optical fiber is connected to the inner cavity to transmit a light ray. In the technical solution in this application, dimension reduction of packaging is performed at a component level, so that a single transistor outline package 110 can combine at least two light rays. Therefore, when the optical sub-assembly is applied to a multi-channel receiving and sending scenario, a quantity of transistor outline packages requiring integration can be reduced, so that a structure of the optical sub-assembly is simpler, a manufacturing process is less difficult, costs are lower, and miniaturization packaging can be implemented.

An optical sub-assembly applied to a passive optical network (PON) is used as an example. The optical sub-assembly is a core component of an access network optical network system. The optical sub-assembly may be applied to a scenario of a 10G PON, a 25G PON, or a 50G PON, or may further be compatible with uplinks and downlinks of at least two of the 2.5G PON, the 10G PON, the 25G PON, and the 50G PON, to implement multiple-transmit multiple-receive transmission on different wavelength channels.

In a specific embodiment, transmitter wavelengths of a dual-transmit dual-receive optical sub-assembly are 1577 nm and 1490 nm, and receiver wavelengths are 1270 nm and 1310 nm.

FIG. 33 is a schematic sectional view of a structure of an optical sub-assembly according to a conventional technology. As shown in FIG. 33, in a conventional technical solution, to implement the foregoing dual-transmit dual-receive optical sub-assembly, the optical sub-assembly needs to integrate and package four transistor outline packages. The four transistor outline packages are a first transistor outline package 140, a second transistor outline package 150, a third transistor outline package 160, and a fourth transistor outline package 170. An optical transmitter chip whose transmitter wavelength is 1577 nm is packaged in the first transistor outline package 140. An optical transmitter chip whose transmitter wavelength is 1490 nm is packaged in the second transistor outline package 150. An optical receiver chip whose receiver wavelength is 1270 nm is packaged in the third transistor outline package 160. An optical receiver chip whose receiver wavelength is 1310 nm is packaged in the fourth transistor outline package 170. The first transistor outline package 140, the second transistor outline package 150, the third transistor outline package 160, and the fourth transistor outline package 170 are packaged and integrated in a transistor 120 of the optical sub-assembly to form a quadruplexer package optical sub-assembly. The optical sub-assembly has a relatively large volume and a relatively long optical path. In addition, this solution requires a complex design of optical paths related to splitting, multiplexing, and coupling, and is difficult to design. Specifically, a plurality of external lenses and optical filters are disposed in the transistor 120 to transmit a light ray. In the embodiment shown in FIG. 32 in this application, an optical sub-assembly with the same function needs to integrate only three transistor outline packages. The three transistor outline packages are a first transistor outline package 140, a second transistor outline package 150, and the transistor outline package 110 in the embodiments of this application. An optical receiver chip whose receiver wavelength is 1310 nm is packaged in the first transistor outline package 140. An optical receiver chip whose receiver wavelength is 1270 nm is packaged in the second transistor outline package 150. In the transistor outline package 110 in the embodiments of this application, the first chip is an optical transmitter chip whose transmitter wavelength is 1490 nm, and the second chip is an optical transmitter chip whose transmitter wavelength is 1577 nm. The optical sub-assembly in this application may be dimension-reduced to a triplexer package. In this embodiment, after a quantity of transistor outline packages in the optical sub-assembly is reduced, a volume of the optical sub-assembly is smaller. Therefore, an optical path for transmitting a light ray in the optical sub-assembly can be shortened. Therefore, all transistor outline packages may use a design of the lens transistor cap 2. Compared with a conventional optical path combination solution of parallel light or relay lenses, a large quantity of external collimating lenses or relay lenses and optical filters are saved, further reducing a package size of a component. In addition, optical paths of transistor outline packages at all ends are independently coupled, and a coupling process is simpler. This solution saves a plurality of processes of surface mounting, adhesive sticking, and coupling at a component level, reduces an overall processing difficulty, and improves production efficiency.

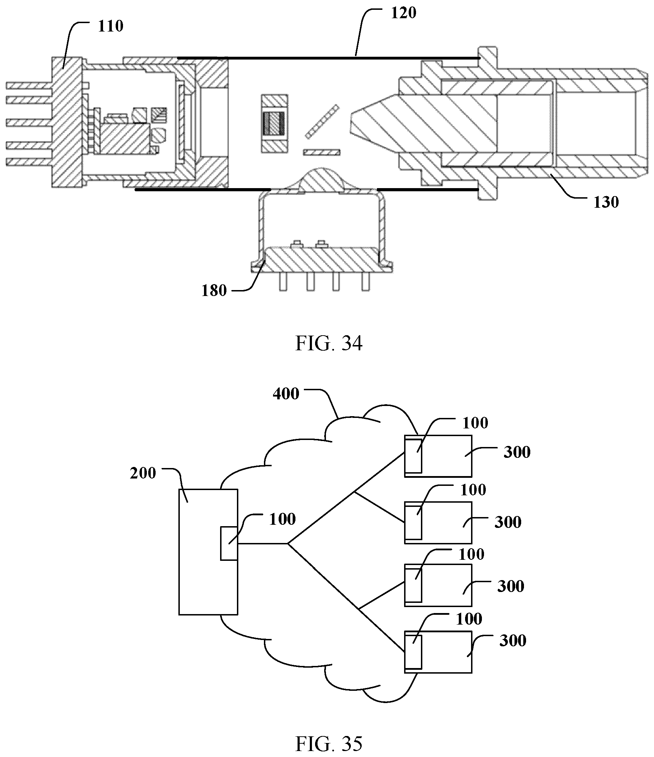

FIG. 34 is a schematic sectional view of another structure of an optical sub-assembly according to an embodiment of this application. As shown in FIG. 34, in another embodiment, an optical sub-assembly with the same function needs to integrate only two transistor outline packages. The two transistor outline packages are a fifth transistor outline package 180 and the transistor outline package 110 in the embodiments of this application. An optical receiver chip whose receiver wavelength is 1310 nm and an optical receiver chip whose receiver wavelength is 1270 nm are packaged in the fifth transistor outline package 180. In the transistor outline package 110 in the embodiments of this application, the first chip is an optical transmitter chip whose transmitter wavelength is 1577 nm, and the second chip is an optical transmitter chip whose transmitter wavelength is 1490 nm. The optical sub-assembly in this application may be dimension-reduced to a unidirectional package, and dual-receiving and dual-sending functions can be implemented by using two transistor outline packages. In this embodiment, after a quantity of transistor outline packages in the optical sub-assembly is reduced, a volume of the optical sub-assembly is smaller. Therefore, an optical path for transmitting a light ray in the optical sub-assembly can be shortened.

In a specific technical solution, the optical sub-assembly may further include an adapter 130. The adapter is mounted on a transistor 120. The adapter can also have a cavity. The cavity is communicated with an inner cavity of the transistor 120. The adapter 130 may be configured to connect to an optical fiber, so that the optical fiber is connected to the inner cavity, and a light ray can be transmitted between the inner cavity and the optical fiber. Certainly, in another embodiment, the optical sub-assembly may alternatively not have an adapter 130, that is, the optical sub-assembly may be a pigtail-type optical sub-assembly. A type of the optical sub-assembly is not specifically limited in this application.

An embodiment of this application further provides an optical module. The optical module includes an outline and the optical sub-assembly in the foregoing embodiment. The foregoing optical sub-assembly is mounted on the outline. In a specific embodiment, the outline may further have an optical fiber port. The optical fiber may transmit an optical signal with the optical sub-assembly through the optical fiber port. The outline of the optical module may further be provided with structures such as a circuit board and a chip disposed on the circuit board. A pin of the transistor outline package is connected to the chip on the circuit board, so that the chip can process a signal sent to the transistor outline package or a signal received by the transistor outline package. This solution helps reduce a volume of the optical module, and implement miniaturization of the optical module. In addition, costs of the optical module can further be reduced.

An embodiment of this application further provides an optical communication system. FIG. 35 is a schematic diagram of a structure of an optical communication system according to an embodiment of this application. As shown in FIG. 35, the optical communication system may be specifically a passive optical communication system. The optical communication system includes an optical line terminal (OLT) 200 and an optical network unit (ONU) 300, and the optical line terminal 200 is connected to the optical network unit 300 via a passive optical distribution network 400. The optical line terminal 200 includes an optical sub-assembly 100, or the optical network unit 300 includes an optical sub-assembly 100. The optical sub-assembly 100 is a basis for normal communication of an entire network. In this solution, a volume of the optical sub-assembly 100 is relatively small, and costs are relatively low. This helps reduce a volume of the optical communication system and reduce costs of the optical communication system.

Still refer to FIG. 35. This application further provides an optical communication apparatus. The optical network apparatus may be specifically the optical line terminal 200 or the optical network unit 300, and the optical communication apparatus includes the optical sub-assembly 100 in any one of the foregoing embodiments. In this solution, a volume of the optical sub-assembly 100 is relatively small, and costs are relatively low. This helps reduce a volume of the optical communication apparatus and reduce costs of the optical network apparatus.

The following describes the passive optical communication system and the optical communication apparatus in the embodiments of this application with reference FIG. 35. In a specific embodiment, the passive optical communication system includes at least one optical line terminal 200, a plurality of optical network units 300, and one passive optical distribution network (ODN) 400. The optical line terminal 200 and the optical network unit 300 are the foregoing optical network apparatuses. The optical line terminal 200 is connected to a plurality of optical network units 300 via the passive optical distribution network 400 in a point-to-multipoint manner. The optical line terminal 200 and the optical network unit 300 may communicate with each other by using a TDM mechanism, a WDM mechanism, or a TDM/WDM hybrid mechanism. A direction from the optical line terminal 200 to the optical network unit 300 is defined as a downlink direction, and a direction from the optical network unit 300 to the optical line terminal 200 is an uplink direction.

The passive optical communication system may be a communication network that does not need any active component to implement data distribution between the optical line terminal 200 and the optical network unit 300. In a specific embodiment, data distribution between the optical line terminal 200 and the optical network unit 300 may be implemented by using the passive optical sub-assembly in the passive optical distribution network 400. The passive optical communication system may be an asynchronous transfer mode passive optical network (ATM PON) system or a broadband passive optical network (BPON) system defined in the ITU-T G.983 standard, a gigabit passive optical network (GPON) system defined in the ITU-TG.984 series standard, an Ethernet passive optical network (EPON) defined in the IEEE 802.3ah standard, a wavelength division multiplexing passive optical network (WDM PON) system, or a next-generation access passive optical network ((NGA PON) system, for example, an XGPON system defined in the ITU-T G.987 series standard, a 10G EPON system defined in the IEEE 802.3av standard, and a TDM/WDM hybrid PON system). All content of various passive optical communication systems defined in the foregoing standards is incorporated in this application document by reference.

The optical line terminal 200 is usually located at a central position (for example, a central office, CO), and may manage a plurality of optical network units 300 together. The optical line terminal 200 may serve as a medium between the optical network units 300 and an upper-layer network (not shown in the figure), to forward data received from the upper-layer network as downlink data to the optical network units 300, and forward uplink data received from the optical network units 300 to the upper-layer network. A specific structure configuration of the optical line terminal 200 may vary according to a specific type of the passive optical communication system. In an embodiment, the optical line terminal 200 includes an optical sub-assembly and a data processing module (not shown in the figure). The optical sub-assembly may convert downlink data processed by the data processing module into a downlink optical signal, send the downlink optical signal to the optical network units 300 via the passive optical distribution network 400, receive an uplink optical signal sent by the optical network units 300 via the passive optical distribution network 400, convert an uplink data signal into an electrical signal, and provide the electrical signal for the data processing module for processing.

The optical network units 300 may be disposed at positions on a customer side (for example, customer premises) in a distributed manner. The optical network units 300 may be network devices configured to communicate with the optical line terminal 200 and a user. Specifically, the optical network units 300 may serve as media between the optical line terminal 200 and the user. For example, the optical network units 300 may forward downlink data received from the optical line terminal 200 to the user, and forward data received from the user to the optical line terminal 200 as uplink data. A specific structure configuration of the optical network unit 300 may vary according to a specific type of the passive optical communication system. In an embodiment, the optical network unit 300 includes an optical sub-assembly. The optical sub-assembly is configured to receive a downlink data signal sent by the optical line terminal 200 via the passive optical distribution network 400, and send an uplink data signal to the optical line terminal 200 via the passive optical distribution network 400. It should be understood that in this application document, a structure of the optical network unit 300 is similar to that of an optical network terminal (ONT). Therefore, in the solution provided in this application, the optical network unit 300 and the optical network terminal may be interchanged.

The passive optical distribution network 400 may be a data distribution system, and may include an optical fiber, an optical coupler, an optical multiplexer/demultiplexer, an optical splitter, and/or another device. In an embodiment, the optical fiber, the optical coupler, the optical multiplexer/demultiplexer, the optical splitter, and/or another device each may be a passive optical device. Specifically, the optical fiber, the optical coupler, the optical multiplexer/demultiplexer, the optical splitter, and/or the another device each may be a device for distributing data signals between the optical line terminal 200 and the optical network units 300 without needing support of a power supply. In addition, in another embodiment, the passive optical distribution network 400 may further include one or more processing devices, for example, an optical amplifier or a relay device. In a branch structure shown in FIG. 1, the passive optical distribution network 400 may specifically extend from the optical line terminal 200 to the plurality of optical network units 300, or may be configured as any other point-to-multipoint structure.

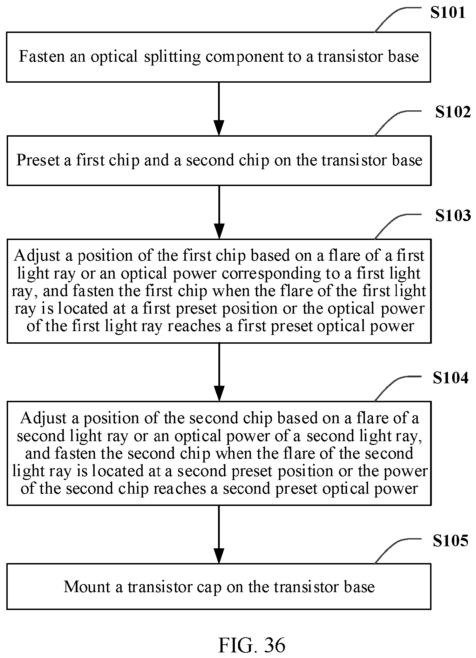

This application further provides a production method for the transistor outline package in the foregoing embodiments. FIG. 36 is a schematic diagram of a production procedure of a transistor outline package according to an embodiment of this application. As shown in FIG. 36, the production method specifically includes the following steps.

S101: Fasten the optical splitting component to the transistor base.

It should be noted that the optical splitting component is fastened relative to the transistor base, but the optical splitting component is not necessarily directly disposed on the base. For example, a mechanical part may further be mounted on the base, and the optical splitting component is mounted on the mechanical part.

S102: Preset the first chip and the second chip on the transistor base.

Herein, the first chip and the second chip are disposed only at approximate positions. Specifically, the first chip may be disposed between the optical splitting component and the base, and the second chip may be disposed between the optical splitting component and the base. In an embodiment, the first chip and the second chip may be disposed on the substrate. In this case, positions of the first chip and the second chip may further be adjusted.

S103: Adjust a position of the first chip based on a flare of the first light ray or an optical power of the first light ray, and fasten the first chip when the flare of the first light ray is located at a first preset position or the optical power of the first light ray reaches a first preset optical power.

The first chip is an optical transmitter chip, that is, the first chip emits the first light ray. After the first light ray is emitted from the optical transmitter chip, the first light ray is emitted to the optical splitting component, and is emitted from the optical splitting component after being adjusted by the optical splitting component. The flare of the first light ray herein is the flare of the first light ray emitted from the optical splitting component. The optical power of the first light ray is the optical power of the first light ray emitted from the optical splitting component. The first preset optical power may be specifically a maximum value of the optical power of the first light ray.

S104: Adjust a position of the second chip based on a flare of the second light ray or an optical power of the second light ray, and fasten the second chip when the flare of the second light ray is located at a second preset position or the power of the second light ray reaches a second preset optical power.

When the second chip is an optical transmitter chip, for an adjustment process of the second chip, refer to step S103. Details are not described herein again. When the second chip is an optical receiver chip, the second light ray is emitted to the optical splitting component, and is emitted from the optical splitting component to the second chip after being adjusted by the optical splitting component. The second chip receives the second light ray, and adjusts the position of the second chip based on the optical power of the second light ray received by the second chip. The second preset optical power may be specifically a maximum value of the optical power of the second light ray.

S105: Mount the transistor cap on the transistor base.

In this embodiment of this application, the transistor outline package is actively assembled. The positions of the first chip and the second chip may be adjusted based on actual situations to ensure a coincidence degree between the first light ray and the second light ray.

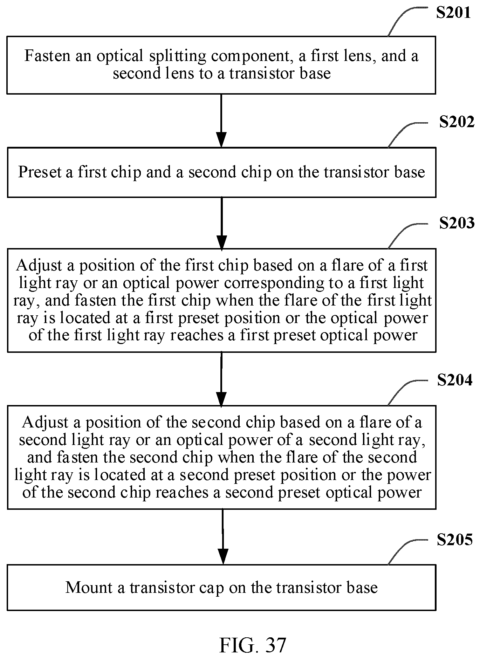

When the transistor outline package further includes a first lens and a second lens, the first lens is disposed between the first chip and the main lens and is configured to adjust a transmission direction of the first light ray, and the second lens is disposed between the second chip and the main lens and is configured to adjust a transmission direction of the second light ray. Based on a same inventive concept, this application further provides another production method for the transistor outline package. FIG. 37 is a schematic diagram of another production procedure of a transistor outline package according to an embodiment of this application. As shown in FIG. 37, the production method specifically includes the following steps.

S201: Fasten the optical splitting component, the first lens, and the second lens to the transistor base.

It should be noted that the optical splitting component, the first lens, and the second lens are fastened relative to the transistor base, but the optical splitting component, the first lens, and the second lens are not necessarily directly disposed on the base. For example, a mechanical part may further be mounted on the base, and the optical splitting component, the first lens, and the second lens are mounted on the mechanical part.

S202: Preset the first chip and the second chip on the transistor base.

Herein, the first chip and the second chip are disposed only at approximate positions. Specifically, the first chip may be disposed on a side of the first lens away from the optical splitting component, and the second chip may be disposed on a side of the second lens away from the optical splitting component. In an embodiment, the first chip and the second chip may be disposed on the substrate. In this case, positions of the first chip and the second chip may further be adjusted.

S203: Adjust a position of the first chip based on a flare of the first light ray or an optical power of the first light ray, and fasten the first chip when the flare of the first light ray is located at a first preset position or the optical power of the first light ray reaches a first preset optical power.

The first chip is an optical transmitter chip, that is, the first chip emits the first light ray. After the first light ray is emitted from the optical transmitter chip to the first lens, the first light ray is emitted to the optical splitting component. The flare of the first light ray herein is the flare of the first light ray emitted from the optical splitting component. The optical power of the first light ray is the optical power of the first light ray emitted from the optical splitting component. The first preset optical power may be specifically a maximum value of the optical power of the first light ray.

S204: Adjust a position of the second chip based on a flare of the second light ray or an optical power of the second light ray, and fasten the second chip when the flare of the second light ray is located at a second preset position or the power of the second chip reaches a second preset optical power.

When the second chip is an optical transmitter chip, for an adjustment process of the second chip, refer to step S203. Details are not described herein again. When the second chip is an optical receiver chip, after the second light ray emitted to the optical splitting component, the second light ray is emitted to the second lens, and then, is emitted to the second chip. The second chip receives the second light ray, and adjusts the position of the second chip based on the optical power of the second light ray received by the second chip. The second preset optical power may be specifically a maximum value of the optical power of the second light ray.

S205: Mount the transistor cap on the transistor base.

Similarly, in this embodiment of this application, the transistor outline package is actively assembled. The positions of the first chip and the second chip may be adjusted based on actual situations to ensure a coincidence degree between the first light ray and the second light ray.

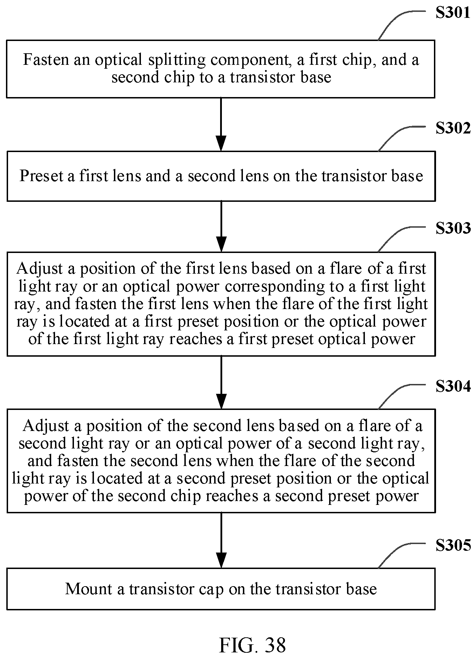

Similarly, when the transistor outline package further includes a first lens and a second lens, the first lens is disposed between the first chip and the main lens and is configured to adjust a transmission direction of the first light ray, and the second lens is disposed between the second chip and the main lens and is configured to adjust a transmission direction of the second light ray. Based on a same inventive concept, this application further provides another production method for the transistor outline package. FIG. 38 is a schematic diagram of another production procedure of a transistor outline package according to an embodiment of this application. As shown in FIG. 38, the production method specifically includes the following steps.

S301: Fasten the optical splitting component, the first chip, and the second chip to the transistor base.

It should be noted that the optical splitting component, the first chip, and the second chip are fastened relative to the transistor base, but the optical splitting component, the first chip, and the second chip are not necessarily directly disposed on the base. For example, a mechanical part may further be mounted on the base, and the optical splitting component, the first chip, and the second chip are mounted on the mechanical part.

S302: Preset the first lens and the second lens on the transistor base.

Herein, the first lens and the second lens are disposed only at approximate positions. Specifically, the first lens may be disposed between the first chip and the optical splitting component, and the second lens may be disposed between the second chip and the optical splitting component. In an embodiment, the first chip and the second chip may be disposed on the substrate. In this case, positions of the first lens and the second lens may further be adjusted.

S303: Adjust a position of the first lens based on a flare of the first light ray or an optical power of the first light ray, and fasten the first lens when the flare of the first light ray is located at a first preset position or the optical power of the first light ray reaches a first preset optical power.

The first chip is an optical transmitter chip, that is, the first chip emits the first light ray. After the first light ray is emitted from the optical transmitter chip to the first lens, the first light ray is emitted to the optical splitting component. The flare of the first light ray herein is the flare of the first light ray emitted from the optical splitting component. The optical power of the first light ray is the optical power of the first light ray emitted from the optical splitting component. The first preset optical power may be specifically a maximum value of the optical power of the first light ray.

S304: Adjust a position of the second lens based on a flare of the second light ray or an optical power of the second light ray, and fasten the second lens when the flare of the second light ray is located at a second preset position or the optical power of the second chip reaches a second preset power.

When the second chip is an optical transmitter chip, for an adjustment process of the second chip, refer to step S303. Details are not described herein again. When the second chip is an optical receiver chip, after the second light ray emitted to the optical splitting component, the second light ray is emitted to the second lens, and then, is emitted to the second chip. The second chip receives the second light ray, and adjusts the position of the second lens based on the optical power of the second light ray received by the second chip. The second preset optical power may be specifically a maximum value of the optical power of the second light ray.

S305: Mount the transistor cap on the transistor base.

In this embodiment of this application, the transistor outline package is actively assembled. The positions of the first lens and the second lens may be adjusted based on actual situations to ensure a coincidence degree between the first light ray and the second light ray.

Based on a same inventive concept, this application further provides a production method for the optical module. The production method includes:
producing a transistor outline package by using the production method for the transistor outline package in any one of the foregoing embodiments, where for example, a production method includes:
fastening the optical splitting component to the transistor base;
presetting the first chip and the second chip on the transistor base;
adjusting a position of the first chip based on a flare of the first light ray or an optical power of the first light ray, and fastening the first chip when the flare of the first light ray is located at a first preset position or the optical power of the first light ray reaches a first preset optical power;
adjusting a position of the second chip based on a flare of the second light ray or an optical power of the second light ray, and fastening the second chip when the flare of the second light ray is located at a second preset position or the power of the second chip reaches a second preset optical power;
mounting the transistor cap on the transistor base to form the transistor outline package;
mounting the transistor outline package on the transistor to form the optical sub-assembly; and
mounting the optical sub-assembly on an outline to form the optical module.

In this embodiment, the transistor outline package is actively assembled. The positions of the first chip and the second chip may be adjusted based on actual situations to ensure a coincidence degree between the first light ray and the second light ray. In this way, signal transmission accuracy of the optical module can be improved to improve working reliability of the optical module.

In another embodiment, when the transistor outline package further includes a first lens and a second lens, the first lens is disposed between the first chip and the main lens and is configured to adjust a transmission direction of the first light ray, and the second lens is disposed between the second chip and the main lens and is configured to adjust a transmission direction of the second light ray. An embodiment of this application further provides another production method. The production method includes:
fastening the optical splitting component, the first lens, and the second lens to the transistor base;
presetting the first chip and the second chip on the transistor base;
adjusting a position of the first chip based on a flare of the first light ray or an optical power of the first light ray, and fastening the first chip when the flare of the first light ray is located at a first preset position or the optical power of the first light ray reaches a first preset optical power;
adjusting a position of the second chip based on a flare of the second light ray or an optical power of the second light ray, and fastening the second chip when the flare of the second light ray is located at a second preset position or the power of the second chip reaches a second preset optical power;
mounting the transistor cap on the transistor base to form the transistor outline package;
mounting the transistor outline package on the transistor to form the optical sub-assembly; and
mounting the optical sub-assembly on an outline to form the optical module.

In this embodiment, the transistor outline package is actively assembled. The positions of the first chip and the second chip may be adjusted based on actual situations to ensure a coincidence degree between the first light ray and the second light ray. In this way, signal transmission accuracy of the optical module can be improved to improve working reliability of the optical module.

In another embodiment, when the transistor outline package further includes a first lens and a second lens, the first lens is disposed between the first chip and the main lens and is configured to adjust a transmission direction of the first light ray, and the second lens is disposed between the second chip and the main lens and is configured to adjust a transmission direction of the second light ray. An embodiment of this application further provides another production method. The production method includes:
fastening the optical splitting component, the first chip, and the second chip to the transistor base;
presetting the first lens and the second lens on the transistor base;
adjusting a position of the first chip based on a flare of the first light ray or an optical power of the first light ray, and fastening the first lens when the flare of the first light ray is located at a first preset position or the optical power of the first light ray reaches a first preset optical power;
adjusting a position of the second chip based on a flare of the second light ray or an optical power of the second light ray, and fastening the second lens when the flare of the second light ray is located at a second preset position or the power of the second chip reaches a second preset optical power;
mounting the transistor cap on the transistor base to form the transistor outline package;
mounting the transistor outline package on the transistor to form the optical sub-assembly; and
mounting the optical sub-assembly on an outline to form the optical module.

In this embodiment, the transistor outline package is actively assembled. The positions of the first lens and the second lens may be adjusted based on actual situations to ensure a coincidence degree between the first light ray and the second light ray. In this way, signal transmission accuracy of the optical module can be improved to improve working reliability of the optical module.

For a specific implementation of a method for forming a transistor outline package, refer to the foregoing embodiments. For brevity, details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A transistor outline package, comprising:
a transistor base;
a transistor cap, disposed on the transistor base, wherein the transistor cap and the transistor base form an accommodation cavity;
a main lens, disposed on a top of the transistor cap and running through the transistor cap, and configured to transmit all light rays, wherein the total light ray comprises a first light ray and a second light ray;
a first chip, disposed in the accommodation cavity, wherein the first light ray is transmitted between the first chip and the main lens, and the first chip is an optical transmitter chip;
a second chip, disposed in the accommodation cavity, wherein the second light ray is transmitted between the second chip and the main lens; and
an optical splitting component, disposed between the first chip and the main lens and configured to adjust a transmission direction of the first light ray, wherein the optical splitting component is further disposed between the second chip and the main lens and is configured to adjust a transmission direction of the second light ray.

2. The transistor outline package according to claim 1, further comprising a first lens and a second lens, wherein the first lens is disposed between the first chip and the main lens and is configured to collimate the first light ray or converge the first light ray, and the second lens is disposed between the second chip and the main lens and is configured to collimate the second light ray or converge the second light ray.

3. The transistor outline package according to claim 2, wherein the first lens and the second lens are integrated.

4. The transistor outline package according to claim 2, wherein the first lens, the second lens, and the optical splitting component are integrated.

5. The transistor outline package according to any one of claims 2 to 4, wherein the optical splitting component is mounted on the first lens and/or the second lens.

6. The transistor outline package according to any one of claims 1 to 5, wherein the first light ray between the optical splitting component and the first chip is perpendicular to the second light ray between the optical splitting component and the second chip.

7. The transistor outline package according to any one of claims 1 to 5, wherein the first light ray between the optical splitting component and the first chip is parallel to the second light ray between the optical splitting component and the second chip, and the first chip and the second chip are located on two sides opposite to the optical splitting component.

8. The transistor outline package according to any one of claims 1 to 5, wherein the first light ray between the optical splitting component and the first chip is parallel to the second light ray between the optical splitting component and the second chip, and the first chip and the second chip are located on a same side of the optical splitting component.

9. The transistor outline package according to any one of claims 6 to 8, wherein the first chip and the second chip are disposed on a same surface.

10. The transistor outline package according to any one of claims 1 to 9, wherein the optical splitting component comprises at least one of an optical filter, an optical splitter, a planar lightwave, a light splitting prism, or a rhomboid prism optical splitter.

11. The transistor outline package according to any one of claims 1 to 10, wherein the second chip is an optical receiver chip, or the second chip is an optical transmitter chip.

12. The transistor outline package according to any one of claims 1 to 10, wherein the total light ray further comprises a third light ray, the transistor outline package further comprises a third chip, the third chip is disposed in the accommodation cavity, and the third light ray is transmitted between the third chip and the main lens; and the optical splitting component is further disposed between the third chip and the main lens and is configured to adjust a transmission direction of the third light ray.

13. The transistor outline package according to claim 12, wherein the total light ray further comprises a fourth light ray, the transistor outline package further comprises a fourth chip, the fourth chip is disposed in the accommodation cavity, and the fourth light ray is transmitted between the fourth chip and the main lens; and the optical splitting component is further disposed between the fourth chip and the main lens and is configured to adjust a transmission direction of the fourth light ray.

14. The transistor outline package according to claim 13, wherein the first chip and the second chip are optical transmitter chips, and the third chip and the fourth chip are optical receiver chips.

15. A production method for the transistor outline package according to any one of claims 1 to 14, comprising:
fastening the optical splitting component to the transistor base;
presetting the first chip and the second chip on the transistor base; and adjusting a position of the first chip based on a flare of the first light ray or an optical power of the first light ray, and fastening the first chip when the flare of the first light ray is located at a first preset position or the optical power of the first light ray reaches a first preset optical power;
adjusting a position of the second chip based on a flare of the second light ray or an optical power of the second light ray, and fastening the second chip when the flare of the second light ray is located at a second preset position or the optical power of the second light ray reaches a second preset power; and
mounting the transistor cap on the transistor base.

16. The production method for the transistor outline package according to any one of claims 1 to 14, wherein the transistor outline package further comprises a first lens and a second lens, the first lens is disposed between the first chip and the main lens, the second lens is disposed between the second chip and the main lens, and the production method comprises:
fastening the optical splitting component, the first lens, and the second lens to the transistor base;
presetting the first chip and the second chip on the transistor base;
adjusting a position of the first chip based on a flare of the first light ray or an optical power of the first light ray, and fastening the first chip when the flare of the first light ray is located at a first preset position or the optical power of the first light ray reaches a first preset optical power;
adjusting a position of the second chip based on a flare of the second light ray or an optical power of the second light ray, and fastening the second chip when the flare of the second light ray is located at a second preset position or the optical power of the second light ray reaches a second preset optical power; and
mounting the transistor cap on the transistor base.

17. The production method for the transistor outline package according to any one of claims 1 to 14, wherein the transistor outline package further comprises a first lens and a second lens, the first lens is disposed between the first chip and the main lens, the second lens is disposed between the second chip and the main lens, and the production method comprises:
fastening the optical splitting component, the first chip, and the second chip to the transistor base;
presetting the first lens and the second lens on the transistor base;
adjusting a position of the first lens based on a flare of the first light ray or an optical power of the first light ray, and fastening the first lens when the flare of the first light ray is located at a first preset position or the optical power of the first light ray reaches a first preset optical power;
adjusting a position of the second lens based on a flare of the second light ray or an optical power of the second light ray, and fastening the second lens when the flare of the second light ray is located at a second preset position or the optical power of the second light ray reaches a second preset power; and
mounting the transistor cap on the transistor base.

18. An optical sub-assembly, comprising a transistor and at least one transistor outline package according to any one of claims 1 to 14, wherein the transistor has an inner cavity, the inner cavity is configured to transmit a total light ray, the transistor outline package is mounted on the transistor, and the main lens transmits the total light ray towards the inner cavity.

19. An optical module, comprising an outline and the optical sub-assembly according to claim 18, wherein the optical sub-assembly is mounted on the outline, the outline has an optical fiber port, and the optical fiber port is configured to connect to an optical fiber.

20. A production method for the optical module according to claim 19, comprising:
fastening the optical splitting component to the transistor base;
presetting the first chip and the second chip on the transistor base; and adjusting a position of the first chip based on a flare of the first light ray or an optical power of the first light ray, and fastening the first chip when the flare of the first light ray is located at a first preset position or the optical power of the first light ray reaches a first preset optical power;
adjusting a position of the second chip based on a flare of the second light ray or an optical power of the second light ray, and fastening the second chip when the flare of the second light ray is located at a second preset position or the optical power of the second light ray reaches a second preset power;
mounting the transistor cap on the transistor base to form the transistor outline package;
mounting the transistor outline package on the transistor to form the optical sub-assembly; and
mounting the optical sub-assembly on an outline to form the optical module.

21. The production method for the optical module according to claim 19, wherein the transistor outline package further comprises a first lens and a second lens, the first lens is disposed between the first chip and the main lens, the second lens is disposed between the second chip and the main lens, and the production method comprises:
fastening the optical splitting component, the first lens, and the second lens to the transistor base;
presetting the first chip and the second chip on the transistor base;
adjusting a position of the first chip based on a flare of the first light ray or an optical power of the first light ray, and fastening the first chip when the flare of the first light ray is located at a first preset position or the optical power of the first light ray reaches a first preset optical power;
adjusting a position of the second chip based on a flare of the second light ray or a power of the second light ray, and fastening the second chip when the flare of the second light ray is located at a second preset position or the optical power of the second light ray reaches a second preset optical power;
mounting the transistor cap on the transistor base to form the transistor outline package;
mounting the transistor outline package on the transistor to form the optical sub-assembly;
and
mounting the optical sub-assembly on an outline to form the optical module.

22. The production method for the optical module according to claim 19, wherein the transistor outline package further comprises a first lens and a second lens, the first lens is disposed between the first chip and the main lens, the second lens is disposed between the second chip and the main lens, and the production method comprises:
fastening the optical splitting component, the first chip, and the second chip to the transistor base;
presetting the first lens and the second lens on the transistor base;
adjusting a position of the first lens based on a flare of the first light ray or an optical power of the first light ray, and fastening the first lens when the flare of the first light ray is located at a first preset position or the optical power of the first light ray reaches a first preset optical power;
adjusting a position of the second lens based on a flare of the second light ray or an optical power of the second light ray, and fastening the second lens when the flare of the second light ray is located at a second preset position or the optical power of the second light ray reaches a second preset power;
mounting the transistor cap on the transistor base to form the transistor outline package;
mounting the transistor outline package on the transistor to form the optical sub-assembly; and
mounting the optical sub-assembly on an outline to form the optical module.

23. An optical communication system, wherein the system comprises an optical line terminal and an optical network unit, the optical line terminal is connected to the optical network unit via a passive optical distribution network, and the optical line terminal comprises the optical sub-assembly according to claim 18 or the optical module according to claim 19, or the optical network unit comprises the optical sub-assembly according to claim 18 or the optical module according to claim 19.
